# EUROPÄISCHE PATENTSCHRIFT

(11) **EP 1 277 238 B1**
(45) Veröffentlichungstag und Bekanntmachung des Hinweises auf die Patenterteilung: **15.09.2010**
(21) Anmeldenummer: 00987008.0
(22) Anmeldetag: 20.10.2000
(51) Int. Cl.: H01L 31/18, H01L 21/324, H01L 21/477, C21D 9/00

(54) **Vorrichtung und Verfahren zum gleichzeitigen Temperieren mehrerer Prozessiergüter**
Device and method for simultaneous tempering of several process goods
Dispositif et procédé pour le recuit simultané de plusieurs produits fabriqués

(30) Priorität: 20.10.1999 DE 19950498
(43) Veröffentlichungstag der Anmeldung: 22.01.2003
(73) Patentinhaber: Saint-Gobain Glass France S.A., 92400 Courbevoie (FR)
(72) Erfinder: PROBST, Volker, 81547 München (DE)
(74) Vertreter: Lendvai, Tomas
(86) Internationale Anmeldenummer: PCT/DE2000/003720
(87) Internationale Veröffentlichungsnummer: WO 2001/029902

(56) Entgegenhaltungen:
- EP-A- 0 399 662
- EP-A- 0 926 719
- WO-A-94/07269
- US-A- 5 926 742
- PATENT ABSTRACTS OF JAPAN vol. 010, no. 319 (E-450), 30. Oktober 1986 (1986-10-30) & JP 61 129834 A (DAINIPPON SCREEN MFG CO LTD), 17. Juni 1986 (1986-06-17)
- PATENT ABSTRACTS OF JAPAN vol. 1995, no. 06, 31. Juli 1995 (1995-07-31) & JP 07 078830 A (HITACHI LTD), 20. März 1995 (1995-03-20)
- PATENT ABSTRACTS OF JAPAN vol. 007, no. 027 (E-156), 3. Februar 1983 (1983-02-03) & JP 57 183041 A (NIPPON DENKI KK), 11. November 1982 (1982-11-11)

## Beschreibung

Die Erfindung betrifft eine Vorrichtung zum gleichzeitigen Temperieren mehrerer Prozessiergüter. Eine Vorrichtung zum Temperieren eines Prozessierguts ist beispielsweise aus EP 0 662 247 B1 bekannt. Neben der Vorrichtung wird ein Verfahren zum Temperieren mehrerer prozessiergüter vorgestellt.

Das aus EP 0 662 247 B1 bekannte Prozessiergut ist ein Mehrschichtkörper, der dadurch hergestellt wird, daß auf eine Trägerschicht (Substrat) eine funktionelle Schicht aufgebracht wird. Damit die funktionelle Schicht und/oder die Trägerschicht eine gewünschte physikalische (elektrisch, mechanisch, etc.) und/oder chemische Eigenschaft aufweist, wird ein Prozessieren des Prozessierguts bzw. der Schicht und/oder der Trägerschicht durchgeführt. Das Prozessieren beinhaltet ein Temperieren des Prozessierguts in Gegenwart eines Gases (Prozeßgas).

Aus EP 0 926 719 A2 ist eine Vorrichtung zur Wärmebehandlung eines SOI-Substrates (SOI = semiconductor on isolator) mit einem Silizium-Einkristall auf der Oberfläche oder mehrere solcher Substrate bekannt.

Zum Temperieren wird das Prozessiergut in einem geschlossenen Temperierbehälter aus Graphit angeordnet. Während des Temperierens ist das Prozessiergut einem Prozeßgase mit gasförmigem Selen ausgesetzt. Beim Temperieren nimmt das Prozessiergut eine Energiemenge auf, wobei jeder Schicht eine Teilmenge der Energiemenge zugeführt wird. Das Temperieren erfolgt beispielsweise mit einer Aufheizrate von 10°C/s. Als Energiequelle der Energiemenge wird eine Halogenlampe benutzt. Mit der Halogenlampe wird der Temperierbehälter aus Graphit mit einer elektromagnetischen Strahlung bestrahlt und somit der Temperierbehälter aufgeheizt. Graphit weist ein hohes Absorptionsvermögen für die elektromagnetische Strahlung im Spektralbereich der Halogenlampe auf. Die durch das Graphit absorbierte Energiemenge wird durch Wärmestrahlung und/oder Wärmeleitung dem Prozessiergut zugeführt. Der Temperierbehälter fungiert somit als sekundäre Energiequelle bzw. als Energietransmitter.

Graphit weist ein hohes Emissionsvermögen und eine hohe Wärmeleitfähigkeit auf. Bei Aufliegen des Prozessierguts auf einem Boden des Temperierbehälterserfolgt die Zufuhr der Energiemenge auf einer Unterseite des Prozessierguts im wesentlichen durch Wärmeleitung. Einer Oberseite des Prozessierguts wird eine Energiemenge durch Wärmestrahlung, Wärmeleitung und Konvektion zugeführt.

Je größer (großflächiger) das Prozessiergut ist, je unterschiedlicher die im Prozessiergut verwendeten Materialien sind (z.B. stark unterschiedlicher Temperaturausdehnungskoeffizient, unterschiedliches Absorptionsvermögen für die Energiemenge etc.) und je höher eine Temperierrate ist (Aufheizrate, Abkühlrate), desto schwieriger ist es, eine Temperaturhomogenität bzw. Temperaturinhomogenität im Prozessiergut zu steuern. Die Temperaturinhomogenität kann zu einer mechanischen Spannung im Prozessiergut und damit zur Zerstörung des Prozessierguts führen. Aus diesem Grund eignet sich die bekannte Vorrichtung mit dem Temperierbehälter in erster Linie zum Temperieren eines einzigen Prozessierguts.

Aufgabe der Erfindung ist es, aufzuzeigen, wie mit einer einzigen Vorrichtung mehrere Prozessiergüter gleichzeitig temperiert werden können unter Steuerung einer Temperaturhomogenität bzw. Temperaturinhomogenität in jedem der Prozessiergüter.

Die Aufgabe der Erfindung wird durch eine Vorrichtung zum gleichzeitigen Temperieren mehrerer Prozessiergüter in einer bestimmten Gasatmosphäre durch Aufnahme einer Energiemenge durch ein Prozessiergut mittels Absorption einer bestimmten elektromagnetischen Strahlung und durch Aufnahme mindestens einer weiteren Energiemenge durch mindestens ein weiteres Prozessiergut mittels Absorption mindestens einer weiteren bestimmten elektromagnetischen Strahlung gelöst, wobei die Vorrichtung eine Temperiereinheit mit mindestens einer Energiequelle zur Erzeugung der elektromagnetischen Strahlung und mindestens eine weitere Temperiereinheit mit mindestens einer weiteren Energiequelle zur Erzeugung der weiteren elektromagnetischen Strahlung aufweist, wobei die Temperiereinheiten einen offenen Temperierbehälter aufweisen, in dem das Prozessiergut angeordnet ist und die Temperierbehälter über verschließbare Gasöffnungen zum Evakuieren und Befüllen der Temperierbehälter mit Prozessgas verfügen, wobei die Temperiereinheiten übereinander zu einem Temperierstapel angeordnet sind, so dass in einer bestimmten Stapelrichtung des Temperierstapels zwischen der Energiequelle der Temperiereinheit und der weiteren Energiequelle der weiteren Temperiereinheit das Prozessiergut und zwischen dem Prozessiergut und dem weiteren Prozessiergut die weitere Energiequelle angeordnet ist und wobei die Gasöffnungen der Temperierbehälter so miteinander verbunden sind, dass eine gemeinsame Prozessgasatmosphäre in den Temperierbehältern geschaffen wird.

Es wird eine Vorrichtung zum Temperieren mehrerer Prozessiergüter in einer bestimmten Gasatmosphäre durch Aufnahme einer Energiemenge durch ein Prozessiergut mittels Absorption einer bestimmten elektromagnetischen Strahlung und durch Aufnahme mindestens einer weiteren Energiemenge durch mindestens ein weiteres Prozessiergut mittels Absorption mindestens einer weiteren bestimmten elektromagnetischen Strahlung angegeben. Die Vorrichtung weist mindestens eine Einrichtung zum Herstellen der Gasatmosphäre, eine Temperiereinheit mit mindestens einer Energiequelle zur Erzeugung der elektromagnetischen Strahlung und mindestens eine weitere Temperiereinheit mit mindestens einer weiteren Energiequelle zur Erzeugung der weiteren elektromagnetischen Strahlung auf. Die Temperiereinheit und die weitere Temperiereinheit sind derart aneinander zu einem Temperierstapel angeordnet, daß in einer bestimmten Stapelrichtung des Temperierstapels zwischen der Energiequelle und der weiteren Energiequelle das Prozessiergut und zwischen dem Prozessiergut und dem weiteren Prozessiergut die weitere Energiequelle angeordnet ist.

Die Energiequelle ist beispielsweise eine Heizerebene, die von einem Heizerarray gebildet ist. Das Heizerarray besteht beispielsweise aus parallel zueinander angeordneten stabförmigen Halogenlampen oder Heizstäben. In dem Temperierstapel sind beispielsweise zwischen den Heizerebenen die Prozessiergüter angeordnet. Durch eine derartige Anordnung eignet sich die Vorrichtung dazu, gleichzeitig mehrere Prozessiergüter zu temperieren. Die Temperiereinheiten können sowohl vertikal als auch horizontal angeordnet sein. Jedem Prozessiergut ist zumindest eine Energiequelle zugeordnet, wobei das Prozessiergut beim Temperieren im Strahlungsfeld der jeweiligen elektromagnetischen Strahlung angeordnet ist. Zur Aufnahme der jeweiligen Energiemenge weisen die Prozessiergüter eine entsprechende Absorption der elektromagnetischen Strahlung auf. Es ist gewährleistet, daß jedes Prozessiergut mit einer für die zum Temperieren notwendigen Energiedichte versorgt wird. Eine gegenseitige Abschattung der Prozessiergüter im Stapel und damit eine ungleichmäßige Bestrahlung der Prozessiergüter durch die elektromagnetischen Strahlungen tritt nicht auf. Die (einstellbare) Gasatmosphäre zeichnet sich beispielsweise durch einen definierten Partialdruck eines Gases oder Gasgemisches (z.B. Luft) aus. Denkbar ist auch, daß die Gasatmosphäre ein Vakuum ist.

In einer besonderen Ausgestaltung der Erfindung weist zumindest eine der Temperiereinheiten zumindest eine zusätzliche Energiequelle zur Erzeugung einer zusätzlichen Energiemenge und zur Aufnahme der zusätzlichen Energiemenge durch das Prozessiergut der Temperiereinheit. Mit der zusätzlichen Energiequelle kann einer unterschiedlichen InfrarotAbsorption von Vorderseite und Rückseite des Prozessiergutes Rechnung getragen werden und damit zur Verbesserung von Temperaturhomogenität des Prozessierguts während des Temperierens beigetragen werden. Außerdem kann durch die zusätzliche Energiequelle eine Erhöhung der Aufheizrate erreicht werden.

Die Aufnahme der zusätzlichen Energiemenge kann im wesentlichen durch Wärmeleitung , Wärmestrahlung und/oder Konvektion erfolgen. Bei der Wärmeleitung steht der Prozessierkörper mit der Energiequelle in Kontakt. Wärmestrahlung wird zumindest teilweise von dem Prozessiergut und dem Prozessierbehälter gemäß deren Absorptionsspektren im Spektralbereich der Heizelemente absorbiert. Bei der Konvektion wird beispielsweise ein Gas, das auch das Prozeßgas sein kann, an dem Prozessierkörper vorbeigeleitet. Dabei kann eine Energiemenge zwischen dem Gas und dem Prozessierkörper ausgetauscht werden.

In einer besonderen Ausgestaltung ist die zusätzliche Energiequelle eine Energiequelle zur Erzeugung einer zusätzlichen elektromagnetischen Strahlung und die Aufnahme der zusätzlichen Energiemenge eine Absorption der zusätzlichen elektromagnetischen Strahlung. In einer weiteren Ausgestaltung ist das Prozessiergut der Temperiereinheit zwischen der Energiequelle der Temperiereinheit und der zusätzlichen Energiequelle der Temperiereinheit angeordnet.

Dadurch ist es möglich, unterschiedliche Seiten des Prozessierguts, beispielsweise eine Ober- und Unterseite eines flachen Prozessierguts, unterschiedlich zu beheizen. Dies ist insbesondere dann vorteilhaft, wenn das Prozessiergut ein Mehrschichtkörper ist, der Schichten aus unterschiedlichem Material aufweist. Die Schichten weisen beispielsweise ein unterschiedliches Absorptionsvermögen für die elektromagnetische Strahlung der Energiequellen bei einem gleichen Temperaturausdehungskoeffizienten auf. Um eine Temperaturinhomogenität in Dickenrichtung des Mehrschichtkörpers zu vermeiden, werden die Schichten beispielsweise mit einer elektromagnetischen Strahlung unterschiedlicher Energiedichte (Energie pro Flächeneinheit) bestrahlt.

In einer besonderen Ausgestaltung ist die Energiequelle, die weitere Energiequelle und/oder die zusätzliche Energiequelle unabhängig voneinander ansteuerbar. Die Energiemenge, die den Prozessiergütern bzw. verschiedenen Schichten der Prozessiergüter zugeführt wird, kann individuell eingestellt bzw. geregelt werden. Beispielsweise sind zwei benachbarte Temperiereinheiten optisch voneinander getrennt, d.h. daß die elektromagnetische Strahlung einer Temperiereinheit nicht in die benachbarte Temperiereinheit abstrahlt. Dies gelingt beispielsweise durch einen für die elektromagnetische Strahlung opaken oder teiltransparenten Körper zwischen den Temperiereinheiten. Dieser Körper ist beispielsweise ein Reflexionskörper (siehe unten). Das Prozessiergut befindet sich zwischen der Energiequelle und der zusätzlichen Energiequelle, so daß auch nur diese Energiequellen zur Temperieren des Prozessierguts beitragen. Die Energiemengen, die dem Prozessiergut in Form von "Oberhitze" und "Unterhitze" zugeführt werden, können auf diese Weise für die einzelnen Schichten des einzelnen Prozessierguts individuell eingestellt werden.

In einer besonderen Ausgestaltung ist die elektromagnetische Strahlung, die weitere elektromagnetische Strahlung und/oder die zusätzliche elektromagnetische Strahlung Infrarotstrahlung (Wärmestrahlung). Denkbar ist eine Energiequelle einer Wärmestrahlung mit einem Intensitätsmaximum bei einer Wellenlänge von 1 µm bis 2 µm. Eine derartige Wärmequelle ist beispielsweise eine Halogenlampe. Denkbar ist auch eine Energiequelle in Form eines Widerstandsheizelements, das die Wärmestrahlung aussendet. Ein derartiges Element weist beispielsweise Graphit, Siliziumkarbid und/oder eine Metall-Legierung wie Nickel-Chrom auf. Denkbar ist darüber hinaus jede elektromagnetische Strahlung (Mikrowellen, UV-Licht), die zu einer Aufheizung des Prozessierguts führen kann.

In einer besonderen Ausgestaltung der Erfindung weist zumindest eine der Temperiereinheiten zumindest einen Reflexionskörper auf zur Formung eines Strahlungsfeldes zumindest einer der elektromagnetischen Strahlungen. Durch den Reflexionskörper wird eine Flußdichte einer elektromagnetischen Strahlung auf ein Prozessiergut gesteuert. Die Flußdichte wird dabei auf das Prozessiergut konzentriert. Der Reflexionskörper weist beispielsweise ein Material auf, das die elektromagnetische Strahlung der Energiequelle zumindest teilweise reflektiert. Der Reflexionskörper kann so angeordnet sein, daß eine reflektierte elektromagnetische Strahlung auf ein Prozessiergut gerichtet ist. Der Reflexionskörper der Temperiereinheit ist beispielsweise zu einer benachbarten Temperiereinheit hin angeordnet. Somit befindet sich der Reflexionskörper quasi zwischen zwei Temperiereinheiten. Denkbar ist auch, daß der Reflexionskörper direkt an einer Energiequelle angeordnet ist. Dabei kann beispielsweise ein bestimmter Öffnungswinkel des Strahlungsfeldes elektromagnetischen Strahlung eingestellt sein.

Der Reflexionskörper kann für die elektromagnetische Strahlung der Energiequelle opak bzw. nahezu opak sein. Dazu weist der Reflexionskörper beispielsweise ein hohes Reflexionsvermögen bei gleichzeitig niedrigem Transmissionsvermögen auf. Insbesondere ist der Reflexionskörper für zumindest eine der elektromagnetischen Strahlungen teildurchlässig. Dies ist dann vorteilhaft, wenn jeder der Temperiereinheiten jeweils über nur eine Energiequelle beispielsweise in Form einer Heizerebene verfügt. Durch den Reflexionskörper gelangt die elektromagnetische Strahlung einer Temperiereinheit in eine benachbarte Temperiereinheit und kann somit zum Temperieren des Prozessierguts der benachbarten Temperiereinheit beitragen. Material und Dicke des Reflexionskörpers sind so ausgewählt, daß ein Transmissions- und Reflexionsspektrum im Bereich der Wellenlänge der elektromagnetischen Strahlung der zugeordneten Energiequelle liegt. Ebenfalls wird hier das Absorptions- und Emissionsvermögen des Prozessierguts berücksichtigt. Transmissions- und Reflexionsvermögen des Reflexionskörpers und Absorptions- und Emissionsvermögen unterschiedlicher Seiten des Prozessierguts werden aufeinander abgestimmt, so daß es während des Temperierens zu keinem unzulässigen Temperaturgradienten im Prozessiergut kommt (beispielsweise in Dickenrichtung des Prozessierguts). Die Temperaturhomogenität ist während des Temperierens gewahrt. Das Material des Reflektorkörpers ist so gewählt, daß eine optische Eigenschaft wie Absorptions- oder Reflexionsvermögen des Reflexionskörpers während des Temperierens im wesentlichen gleich bleibt. Als Reflexionsörper kommen entsprechend des gewünschten Reflexionsspektrums gängige Reflektormaterialien in Betracht. Vorteilhaft ist der Reflexionskörper aus Keramik, oder Quarzgut. Diese Materialien sind gegenüber einer Vielzahl von Prozeßgasen inert. Der Reflexionskörper kann auch eine reflektierende, chemisch reaktionsträge Beschichtung wie Bariumsulfat oder Aluminiumoxid auf einem Trägerkörper aus Glaskeramik oder Quarzglas aufweisen. Denkbar ist auch, daß beispielsweise eine Hologenlampenhülle die Beschichtung aufweist. Vorstellbar ist auch eine Reflexionskörper mit einer Metallbeschichtung.

In einer weiteren Ausgestaltung der Erfindung weist zumindest eine der Temperiereinheiten mindestens ein Mittel zum Kühlen des Prozessierguts auf. Damit verbindet sich der Vorteil, daß ein Prozeßablauf umfassend verschiedene Verfahrensstufen mit mindestens einer Aufheizphase und Abkühlphase mit Hilfe der gleichen Vorrichtung durchgeführt werden kann. Das Mittel zum Kühlen ist insbesondere ein Kühlgas und/oder eine Kühlflüssigkeit. Das Kühlen erfolgt mit Hilfe des Kühlgases durch Konvektion, wobei beispielsweise ein im Vergleich zum Prozessiergut kühleres Kühlgas am Prozessiergut vorbeigeleitet wird. Das Kühlen kann auch durch Wärmeleitung erfolgen, wobei das Prozessiergut mit einem Kühlkörper mit einem entsprechenden Temperaturleitfähigkeitskoeffizienten in Kontakt steht. Denkbar ist, das der Kühlkörper eine Ummantelung der Temperiereinheit und/oder des Temperierstapels mit einem Hohlraum ist, durch den das Kühlgas oder die Kühlflüssigkeit geleitet werden kann.

In einer weiteren Ausgestaltung der Erfindung ist zumindest eine der Energiequellen in einer Umhüllung angeordnet, die für die elektromagnetischen Strahlung der Energiequelle zumindest teilweise transparent ist. Beispielsweise besteht die Umhüllung aus Quarzglas. Vorzugsweise ist die Umhüllung vakuumdicht. Mit Hilfe der Umhüllung kann die Energiequelle vor einem Kontakt mit einem Prozeßgas geschützt werden. Ein weiterer Vorteil dieser Ausgestaltung ist ein einfaches Auswechseln der Energiequelle.

In einer besonderen Ausgestaltung weist die Umhüllung der Energiequelle einen optischen Filter für die elektromagnetische Strahlung der Energiequelle auf. Damit kann gezielt auf die optische Eigenschaft (Absorptions- und Transmissionsvermögen) der Umhüllung Einfluß genommen werden.

In einer besonderen Ausgestaltung der Erfindung weist die Umhüllung der Energiequelle das Mittel zum Kühlen auf. Insbesondere ist dabei das Mittel zum Kühlen in der Umhüllung der Energiequelle angeordnet. Dabei wird beispielsweise nicht nur das Prozessiergut, sondern auch die Energiequelle gekühlt. Das führt zu einer schnellen Abnahme einer von der Energiequelle abgestrahlten Energiedichte und damit zu einem effizienten Kühlen des Prozessierguts. Besonders dann, wenn hohe Energiedichten und/oder hohe Temperaturhomogenität gefordert sind, werden die Energiequellen, insbesondere Halogenlampen, in einem nur geringen Abstand zum Prozessiergut angeordnet, so daß neben einer hohen Strahlungsintensität auch eine hohe Kühlleistung zur Verfügung steht. Bei größeren Abständen zwischen den Energiequellen können bei hoher geforderter Kühlleistung zwischen den Energiequellen zusätzliche Kühlelemente angeordnet sein. Ein derartiges Kühlelement ist beispielsweise ein Rohr, durch das ein Kühlgas oder eine Kühlflüssigkeit geleitet wird. Denkbar ist beispielsweise eine Ummantelung der Umhüllung, durch die die Kühlflüssigkeit zum Abkühlen strömt. Denkbar ist auch ein Kombination von Kühlgas und Kühlflüssigkeit. Zur Vermeidung eines Temperaturschocks kann zunächst durch den Zwischenraum zwischen Ummantelung und Energiequelle ein Kühlgas geleitet werden. In einem weiteren Schritt wird zur effizienten Kühlung die Kühlflüssigkeit durch die Ummantelung gepumpt. In einer weiteren Ausgestaltung weist die Umhüllung der Energiequelle den Reflexionskörper auf. Insbesondere ist dabei der Reflexionskörper in der Umhüllung der Energiequelle angeordnet. Auf diese Weise gibt es keinerlei Einschränkung bezüglich einer Reaktivität des Materials des Reflexionskörpers gegenüber einem Prozeßgas. Einzig ausschlaggebend sind die optischen Eigenschaften des Reflexionskörpers.

In einer weiteren Ausgestaltung weist die Umhüllung der Energiequelle einen optischen Filter für die Wärmestrahlung der Energiequelle auf. Insbesondere ist dabei der optische Filter in der Umhüllung der Energiequelle angeordnet. Auf diese Weise gibt es keinerlei Einschränkung bezüglich einer Reaktivität des Materials des optischen Filters gegenüber einem Prozeßgas. Einzig ausschlaggebend sind die optischen Eigenschaften des Filters. Der optische Filter kann dann so gewählt sein, daß das gewünschte Spektrum der Energiequelle erzielt wird.

In einer besonderen Ausgestaltung der Erfindung weist zumindest eine der Temperiereinheiten einen eine Behälterwandung aufweisenden Temperierbehälter zum Haltern des Prozessierguts der Temperiereinheit auf. Der Temperierbehälter dient dabei einem Anordnen des Prozessierguts im Strahlungsfeld einer der elektromagnetischen Strahlungen. Denkbar ist, daß die Behälterwandung selbst die Energiequelle der elektromagnetischen Strahlung aufweist. Beispielsweise ist die Wandung aus Graphit, das während des Temperierens mit elektrischem Strom durchflossen wird.

Von besonderem Vorteil kann es sein , wenn eine Behälterwandung, die als Auflagefläche für das Prozessiergut fungiert, eine Abgabe der Energiemenge an das Prozessiergut mittels Wärmeleitung ermöglicht. Dazu weist die Behälterwandung eine entsprechende Temperaturleitfähigkeit auf. Dies ist besonders dann vorteilhaft, wenn das Prozessiergut eine geringe Absorption im Spektrum der Energiequellen aufweist. Die Auflagefläche besteht dann aus einem Material, das eine hohe Absorption im Spektrum der Energiequelle aufweist.

In einer weiteren Ausgestaltung der Erfindung weist der Temperierstapel einen Stapelkorpus mit einer Korpuswandung auf. Der Stapelkorpus dient beispielsweise als Halterung für die Temperiereinheiten und/oder als Reflexionskörper für die Wärmestrahlung und/oder als umhüllender Isolationskörper des Temperierstapels. In einer besonderen Ausgestaltung der Erfindung ist der Stapelkorpus temperierbar. Dadurch kann eine Temperierrate der Prozessiergüter zusätzlich beeinflußt werden. Der Stapelkorpus ist beispielsweise ein Gerüst mit einer Einschubebene bzw. einer Einschubschiene für jeweils eine Temperiereinheit, eine Energiequelle, ein Prozessiergut und/oder einer Auflagefläche eines Prozessierguts.

Der Stapelkorpus weist vorteilhaft einen Hohlraum auf, der evakuierbar und mit dem Prozeßgas befüllbar ist. In diesem Hohlraum werden dabei die Temperiereinheiten zum Temperierstapel angeordnet. Denkbar ist auch, daß eine Korpuswandung des Stapelkorpus die Behälterwandung des Temperierbehälters aufweist. Dadurch kann beispielsweise der Stapelkorpus im wesentlichen von den Behälterwandungen der Temperierbehälter gebildet sein. Die Temperierbehälter werden übereinander zum Stapelkorpus gestapelt. Dabei können die Temperierbehälter mit Hilfe von Löchern und Aussparungen so gestaltet sein, daß ein gemeinsamer Hohlraum der Temperierbehälter vorhanden ist.

Mit Hilfe des evakuierbaren und mit dem Prozeßgas befüllbaren Stapelkorpus wird eine gemeinsame Prozeßgasatmosphäre für alle in den Temperierbehältern angeordneten Prozessiergütern geschaffen. Diese Ausgestaltung kann dann vorteilhaft sein, wenn eine große Menge an Prozeßgas bei möglichst geringem Gasfluß erforderlich ist.

In einer weiteren Ausgestaltung der Erfindung ist der Temperierstapel und/oder der Stapelkorpus in einer Temperierkammer mit einer Kammerwandung angeordnet. Die Temperierkammer ist in einer weiteren Ausgestaltung evakuierbar und mit dem Prozeßgas befüllbar. Beispielsweise verfügt die Temperierkammer über eine verschließbare Tür, durch die die Temperierbehälter, die sich in der Temperierkammer befinden, mit den Prozessiergütern bestückt werden können. Denkbar ist auch, daß durch die Tür der Stapelkorpus in die Temperierkammer eingesetzt werden kann. Ebenso kann eine Temperiereinheit direkt in einer Temperierkammer an einer passenden Schiene eingeschoben sein. Die Temperierkammer fungiert als Halterung der Temperiereinheiten.

Insbesondere ist die Temperierkammer mit einer vakuumdichten Türe versehen, an der im Inneren der Temperierkammer eine Tür des Stapelkorpus angeordnet ist, die unabhängig von der Tür der Temperierkammer geöffnet und geschlossen werden kann. Dadurch kann die Gasatmosphäre im Stapelkorpus bzw. auch in den Temperierbehältern leicht gesteuert werden, ohne daß die Temperierkammer geöffnet werden muß.

Insbesondere ist die Temperierkammer und/oder der Stapelkorpus temperierbar. Dies ist insbesondere dann vorteilhaft, wenn beim Temperieren an einer Oberfläche des Stapelkorpus und/oder der Temperierkammer ein Edukt und/oder Produkt des Prozessierens kondensiert. Zudem kann ein Gasdruck im Inneren der Temperierkammer gesteuert werden. Zur Erhöhung einer Leistungsdichte der jeweiligen elektromagnetischen Strahlung kann der Stapelkorpus und/oder die Temperierkammer einen Reflexionskörper bzw. eine Reflexionsbeschichtung aufweisen.

In einer besonderen Ausgestaltung weist die Behälterwandung, die Korpuswandung und/oder die Kammerwandung die Einrichtung zum Herstellen der Gasatmosphäre auf. Die Einrichtung ist in der Erfindung eine Gasöffnung für zumindest ein Gas zum Evakuieren und/oder Befüllen des Temperierbehälters, des Stapelkorpus und/oder der Temperierkammer mit dem Gas. Das Gas ist insbesondere ein Prozeßgas und/oder ein Spülgas. Als Prozeßgas kommen alle denkbaren korrosiven und nichtkorrosiven Gase in Frage. Beispiele hierfür sind oxidierende Gase wie Sauerstoff oder ein molekulares Halogen und reduzierende Gase wie Wasserstoff Schwefelwasserstoff, Selenwasserstoff, Dotiergase oder ähnliches. Denkbar ist beispielsweise, daß während des Temperierens in einer ersten Temperierstufe ein erstes Prozeßgas benötigt wird, hingegen bei einer weiteren Temperierstufe ein weiteres Prozeßgas. Denkbar ist auch, daß innerhalb einer Temperierstufe das Prozeßgas nachgefüllt werden muß. Als Spülgas kommt beispielsweise Stickstoff oder ein anderes Inertgas in Frage. Es dient einer Reinigung des Temperierbehälters, des Stapelkorpus und/oder der Temperierkammer. Darüber hinaus kann zur Reinigung und/oder zur Prozessierung bzw. Temperierung Vakuum angelegt sein.

In der Erfindung stehen durch die Gasöffnung das Prozessiergut und das weitere Prozessiergut miteinander in Kontakt. Beispielsweise ist ein Gasauslaß des Temperierbehälters mit einem Gaseinlaß eines weiteren Temperierbehälters verbunden. Dadurch entsteht in den beiden Temperierbehältern eine gemeinsame Gasatmosphäre. Es können beispielsweise beide Prozessiergüter mit einem gleichen Gasstrom in Kontakt gebracht werden. Es ist aber auch möglich, für jeden Temperierbehälter einen eigenen Gaseinlaß und Gasauslaß bereitzustellen.

Eine Möglichkeit zum Evakuieren und zum Befüllen der Temperierbehälter, des Stapelkorpus und oder der Temperierkammer ist besonders vorteilhaft bei Verwendung eines toxischen und/oder korrosiven Prozeßgases. Nicht zuletzt aus Sicherheitsgründen ist bei Verwendung derartiger Gase eine Kontrolle der jeweiligen Prozeßgasatmosphäre und eine Reinigung der Behälter wichtig.

In einer weiteren Ausgestaltung der Erfindung ist zumindest eines der Prozessiergüter ein Mehrschichtkörper mit zumindest einer Schicht, die eine bestimmte Absorption zumindest einer der elektromagnetischen Strahlungen aufweist.

In einer besonderen Ausgestaltung der Erfindung weist zumindest eine der Temperiereinheiten zumindest einen Transparenzkörper auf, der eine bestimmte Absorption und eine bestimmte Transmission für zumindest eine der elektromagnetischen Strahlungen aufweist und der im Strahlungsfeld der elektromagnetischen Strahlung zwischen der Energiequelle der elektromagnetischen Strahlung und einem der Prozessiergüter angeordnet ist. Der besondere Vorteil des Transparenzkörpers insbesondere beim Temperieren eines Mehrschichtkörpers ist weiter unten im Zusammenhang mit der Ausgestaltung der Temperiereinheit ausgeführt.

In einer besonderen Ausgestaltung der Erfindung weist die Umhüllung der Energiequelle, der Temperierbehälter, der Stapelkorpus, die Temperierkammer der Transparenzkörper und/oder der Reflexionskörper ein Material auf, das gegenüber dem Gas inert ist. Insbesondere ist das Material aus der Gruppe Glas, Quarzglas, Quarzgut, Keramik, Glaskeramik und/oder Metall ausgewählt. Diese Materialien sind gegenüber einer Vielzahl von Prozeßgasen inert, d.h. reaktionsträge. Zudem haben einige Materialien wie Quarzglas oder Glaskeramik einen niedrigen Temperaturausdehungskoeffizienten. Dies ist bei einer Vorrichtung besonders wichtig, die aus Bestandteilen aus verschiedenen Materialien zusammengesetzt ist. Innerhalb einer zulässigen Toleranz kann sich eine Abmessung eines Bestandteils ändern. Dies gewährleistet, daß die Vorrichtung während des Temperierens nicht aufgrund einer mechanischen Spannung zerstört wird, d.h. erhalten bleibt. Außerdem ist dadurch eine Kontrolle einer Gasatmosphäre leichter möglich. Ein möglicher Spalt eines Bestandteils oder zwischen den Bestandteilen der Vorrichtung ändert sich durch den niedrigen thermischen Ausdehnungskoeffizienten seiner Bestandteile während des Temperierens kaum. Ein zusätzlicher Vorteil ergibt sich durch eine Verwendung eins maschinenbearbeitbaren Materials (z.B. maschinenbearbeitbare Keramik, Glaskeramik oder maschinenbearbeitbares Quarzgut).

Im folgenden wird beschrieben, wie durch verschiedene Ausgestaltungen der Temperiereinheit gewährleistet wird, daß großflächige Prozessiergüter, insbesondere Mehrschichtkörper mit einer unsymmetrischen Schichtfolge, temperiert werden können unter Steuerung einer Temperaturhomogenität der Prozessiergüter.

Das Prozessiergut der Temperiereinheit ist beispielsweise ein Mehrschichtkörper, der eine erste Schicht und mindestens eine zweite Schicht aufweist. Die Temperierung erfolgt durch Aufnahme einer Energiemenge durch den Mehrschichtkörper mit einer Aufnahme einer ersten Teilmenge der Energiemenge durch die erste Schicht und einer Aufnahme einer zweiten Teilmenge der Energiemenge durch die zweite Schicht. Die Temperiereinheit, die mindestens eine Energiequelle der Energiemenge aufweist, ist dadurch gekennzeichnet, daß die erste Schicht zwischen einer ersten Energiequelle und der zweiten Schicht und die zweite Schicht zwischen einer zweiten Energiequelle und der ersten Schicht angeordnet ist. Mindestens eine der Energiequellen weist eine Emission einer bestimmten elektromagnetischen Strahlung mit einem Strahlungsfeld auf und mindestens eine der Schichten weist eine bestimmte Absorption für diese elektromagnetische Strahlung auf und ist in dem Strahlungsfeld angeordnet. Darüber hinaus ist in dem Strahlungsfeld zwischen der Energiequelle mit dem Strahlungsfeld und der Schicht, die die Absorption der elektromagnetischen Strahlung aufweist und die im Strahlungsfeld angeordnet ist, mindestens ein Transparenzkörper angeordnet, der eine bestimmte Transmission und eine bestimmte Absorption für die elektromagnetische Strahlung aufweist.

Mit Hilfe des Transparenzkörpers gelingt es, die Schichten des Mehrschichtkörpers individuell aufzuheizen, d.h. die Teilmenge der Energiemenge, die eine Schicht aufnimmt, gezielt zu steuern, zu regulieren und/oder voreinzustellen. Beispielsweise wird eine Energiemenge mit Hilfe eines Regelkreises während des Temperierens bestimmt (siehe unten). Denkbar ist auch, daß eine Voreinstellung der Energiequellen (z.B. Energiedichte, Art der Energie, etc.) ohne einen zusätzlichen Regelkreis ausreicht. Es ist ein individuelles Aufheizen der Schichten des Mehrschichtkörpers auch bei sehr hohen Aufheizraten von 1°C/s bis beispielsweise 100°C/s und mehr möglich. Durch das individuelle Aufheizen gelingt es, während des Temperierens eine mechanische Spannung und eine damit unter Umständen auftretende Verformung des Mehrschichtkörpers möglichst klein zu halten.

Basis dafür ist der Transparenzkörper, der optisch teildurchlässig (semitransparent) ist. Durch die Transmission, die beispielsweise bei einer bestimmten Wellenlänge zwischen 0,1 und 0,9 liegt, gelangt die oben beschriebene elektromagnetische Strahlung durch den Transparenzkörper auf eine Schicht. Die Schicht kann eine entsprechende Energiemenge bzw. Teilmenge der Energiemenge aufnehmen, die direkt von der Energiequelle ausgesendet wird.

Der Transparenzkörper weist auch eine gewisse Absorption für die elektromagnetische Strahlung auf. Die damit aufgenommenen Energie kann in Form von Wärmestrahlung und/oder Wärmeleitung an eine Umgebung abgegeben werden. In einer besonderen Ausgestaltung verfügt die Vorrichtung zum Temperieren eines Mehrschichtkörpers einen Transparenzkörper, der durch die Absorption der elektromagnetischen Strahlung eine Wärmestrahlung und/oder Wärmeleitung in Richtung des Mehrschichtkörpers aufweist. Somit gelingt es, eine Schicht durch Wärmestrahlung und/oder Wärmeleitung zu temperieren.

Denkbar ist auch, daß eine erste Schicht des Mehrschichtkörpers, die für die Wärmestrahlung eine Transmission zeigt, im wesentlichen nur durch Wärmeleitung temperiert wird, während eine zweite Schicht desselben Mehrschichtkörpers durch die Wärmestrahlung desselben Transparenzkörpers im wesentlichen temperiert wird. Eine erste Schicht mit einer entsprechenden Transmission ist beispielsweise eine Schicht aus Glas. Wenn eine elektromagnetische Strahlung einer Energiequelle und/oder eines Transparenzkörpers auf den Glaskörper trifft, wird ein geringer Anteil der Strahlung (etwa 4%) reflektiert. Der größte Anteil (>90%) gelangt mehr oder weniger ungehindert durch das Glas und trifft dann auf eine zweite Schicht des Mehrschichtkörpers. Dort kann diese Strahlung absorbiert werden und zu einer Aufnahme einer Energiemenge durch diese zweite Schicht führen. Die Glasschicht kann durch Strahlung bzw. Wärmestrahlung bei einer sehr hohen Aufheizrate nicht ausreichend schnell temperiert werden. Dagegen ist ein relativ schnelles Temperieren durch Wärmeleitung möglich, wenn der Transparenzkörper eine Teilmenge der Energiemenge aufnehmen und auf die Glasschicht übertragen kann.

Denkbar ist auch der Fall, daß der Transparenzkörper selbst eine Schicht des Mehrschichtkörpers ist. Der Transparenzkörper kann durch Absorption eines Teils der elektromagnetischen Strahlung eine Teilmenge der Energiemenge aufnehmen und durch die Transmission eine weitere Teilmenge der Energiemenge zur Aufnahme durch eine weitere Schicht durchlassen.

In einer besonderen Ausgestaltung der Temperiereinheit ist eine Schicht des Mehrschichtkörpers eine Trägerschicht für zumindest eine weitere Schicht des Mehrschichtkörpers. Der Mehrschichtkörper weist insbesondere eine unsymmetrische Schichtfolge auf. Beispielsweise besteht der Mehrschichtkörper aus einer einseitig beschichteten Trägerschicht. Einzelne Schichten des Mehrschichtkörpers können auch nebeneinander angeordnet sein.

In einer besonderen Ausgestaltung weist eine Schicht des Mehrschichtkörpers ein Material auf, das aus der Gruppe Glas, Glaskeramik, Keramik, Metall und/oder Kunststoff ausgewählt ist. Als Kunststoff kommt insbesondere temperaturbeständiger Kunststoff wie Teflon in Frage. Eine Schicht ist beispielsweise eine Metallfolie. Die Metallfolie kann auch als Trägerschicht fungieren.

Die Teilmenge der Energiemenge, die von einer Schicht aufgenommen wird, hängt beispielsweise von dem Absorptions-, Emissions- und/oder Reflexionsvermögen der Schicht ab. Sie hängt aber auch von der Art der Energiequelle ab und von der Art und Weise, wie die Energiemenge auf den Mehrschichtkörper bzw. auf eine Schicht des Mehrschichtkörpers übertragen wird.

Eine der Energiequellen der Temperiereinheit ist beispielsweise eine Energiequelle für thermische Energie. Dabei kann der Schicht die thermische Energie direkt zugeführt werden. Hier kommt Wärmestrahlung, Wärmeleitung und/oder Konvektion in Frage. Im Fall der Wärmestrahlung kann die Energiequelle selbst eine Quelle für Wärmestrahlung sein. Die Wärmestrahlung ist beispielsweise elektromagnetische Strahlung im Wellenlängenbereich zwischen 0,7 und 4,5 µm. Die entsprechende Schicht ist im Strahlungsfeld der Energiequelle angeordnet. Die Schicht wird von der elektromagnetischen Strahlung der Energiequelle getroffen und absorbiert zumindest teilweise die elektromagnetische Strahlung.

Möglich ist es aber auch, daß einer Schicht eine beliebige Energie zugeführt wird, die in der Schicht in thermische Energie umgewandelt wird. Beispielsweise wird eine Schicht mit hochenergetischem UV-Licht bestrahlt, das die Schicht absorbiert. Durch eine Absorption eines hochenergetischen Lichtquants gelangt ein Molekül der Schicht oder die ganze Schicht in einen elektronisch angeregten Zustand. Eine dabei aufgenommene Energie kann in thermische Energie umgewandelt werden.

Neben Wärmestrahlung und Wärmeleitung ist auch ein Temperieren einer Schicht bzw. des ganzen Körpers durch Konvektion möglich. Dabei wird ein Gas mit einer bestimmten Energie an der Schicht vorbeigeleitet, wobei das Gas die Energie an die Schicht abgibt. Vorbeigeleitetes Gas kann gleichzeitig als Prozeßgas fungieren.

Durch Wärmeleitung und/oder Konvektion kann im übrigen eine Schicht auch gekühlt werden. Dabei wird der Schicht eine negative thermische Energie zugeführt. Auf diese Weise ist es auch möglich, die Energiemengen bzw. die Teilmengen der Energiemengen zu steuern und z.B. die mechanischen Spannungen im Mehrschichtkörper zusätzlich zu beeinflussen.

In einer besonderen Ausgestaltung ist ein Energietransmitter zur Übertragung der Energiemenge auf den Mehrschichtkörper vorhanden. Der Energietransmitter fungiert als sekundäre Energiequelle. Der Energietransmitter absorbiert beispielsweise elektromagnetische Strahlung einer primären Energiequelle, z.B. einer Halogenlampe, aus einem höheren Energiebereich und konvertiert diese elektromagnetische Strahlung in Wärmestrahlung, die von der Schicht absorbiert wird.

Als Energietransmitter kann die mittelbare und/oder unmittelbare Umgebung des Mehrschichtkörpers während des Temperierens fungieren. Denkbar ist, daß ein Energietransmitter mit dem Mehrschichtkörper zum Temperieren in einem Innenraum eines Temperierbehälters angeordnet ist. Der Energietransmitter kann auch außerhalb des Temperierbehälters, beispielsweise auf einer Wandung des Temperierbehälters oder in einem Abstand zum Temperierbehälter angeordnet sein. Denkbar ist, daß der Energietransmitter eine Beschichtung des Temperierbehälters ist. Der Energietransmitter ist beispielsweise eine Graphitfolie. Der Temperierbehälter kann auch selbst die Funktion eines Energietransmitters übernehmen. Eine derartige Funktion ist beispielsweise bei einem Temperierbehälter aus Graphit gegeben. Schließlich ist der Transparenzkörper nichts anderes als ein Energietransmitter. Ebenso fungiert ein Gas bei einer Energieübertragung durch Konvektion als Energietransmitter.

Eine Energiemenge, die der Mehrschichtkörper aufnimmt, kann nicht nur von Schicht zu Schicht, sondern auch innerhalb einer Schicht unterschiedlich sein. Beispielsweise tritt während des Temperierens ein Randeffekt im Mehrschichtkörper bzw. in einer Schicht eines Mehrschichtkörpers auf. Ein Randbereich der Schicht weist eine andere Temperatur auf als ein innerer Bereich der Schicht. Es stellt sich während des Temperierens ein lateraler Temperaturgradient ein. Dies geschieht beispielsweise dann, wenn ein Strahlungsfeld der Energiequelle inhomogen ist. Dabei ist eine Energiedichte des Stahlungsfeldes auf einer Fläche, die von der Strahlung durchstrahlt wird, nicht überall gleich. Eine laterale Temperaturinhomogenität kann sich auch bei einem homogenen Strahlungsfeld einstellen, wenn am Rand einer Schicht aufgrund der größeren absorbierenden Fläche pro Volumeneinheit eine größere Energiemenge pro Volumeneinheit absorbiert wird. Um den Temperaturunterschied auszugleichen, kann beispielsweise eine Energiequelle verwendet werden, die aus einer Vielzahl von Untereinheiten besteht. Jede Untereinheit kann separat angesteuert werden und so jede von einer Untereinheit auf eine Schicht zugeführte Energiemenge separat eingestellt werden. Eine derartige Energiequelle ist beispielsweise ein Array oder eine Matrix aus einzelnen Heizelementen. Ein Heizelement ist beispielsweise eine Halogenlampe. Das Array oder die Matrix kann auch dazu benutzt werden, einen lateralen Temperaturgradienten in der Schicht herzustellen. Dadurch könnte man beispielsweise eine permanente oder transiente Verformung des Schichtkörpers gezielt erzeugen. Insbesondere für die Temperierung eines Mehrschichtkörpers, bei dem Schichten nebeneinander liegen, ist ein Array oder eine Matrix von großem Vorteil.

Bezüglich der Energiequelle ist es vorteilhaft, wenn die Energiequelle bzw. die Energiequellen in einem kontinuierlichen Betrieb arbeiten. Denkbar ist aber auch, daß die Energiequellen in einem Zyklus- und/oder Pulsbetrieb die Energiemenge bzw. die Teilmengen der Energiemenge den Schichten zur Verfügung stellen. Eine derartige Energiequelle ist beispielsweise eine Energiequelle mit gepulster elektromagnetischer Strahlung. Auf diese Weise kann den Schichten zur gleichen Zeit oder in einer zeitlichen Abfolge (z.B. alternierend) eine Energiemenge zugeführt werden.

Folgende Eigenschaften einer Energiequelle für elektromagnetische Strahlung sind besonders vorteilhaft:
- Die Energiequelle weist ein homogenes Strahlungsfeld auf.
- Eine spektrale Intensitätsverteilung der Energiequelle überlappt teilweise mit einer spektralen Absorption der Schicht, des Transparenzkörpers und/oder eines eventuell vorhandenen Temperierbehälters (siehe unten).
- In Gegenwart eines Prozeßgases ist die Energiequelle korrosionsfest und/oder korrosionsgeschützt.
- Die Energiequelle weist eine hohe Energiedichte auf, die ausreicht, um eine Masse des Mehrschichtkörpers (und eventuell die eines Temperierbehälters) mit einer Aufheizrate von über 1°C/s aufheizen zu können.

In einer besonderen Ausgestaltung weist der Transparenzkörper der Vorrichtung mindestens einen Abstandshalter auf, an dem der Mehrschichtkörper anliegt, zur Aufnahme einer lateral homogenen Energiemenge durch den Mehrschichtkörper. Beispielsweise wird der Schicht, über die der Mehrschichtkörper auf dem Transparenzkörper bzw. dem Abstandshalter aufliegt, in erster Linie durch eine homogene Wärmestrahlung temperiert. In dieser Form weist der Abstandshalter vorzugsweise ein Material auf, das eine geringe Absorption für die elektromagnetische Strahlung aufweist. Ein Abstandshalter überragt beispielsweise eine Oberfläche des Transparenzkörpers um einige µm bis mm.

Die auf den Abstandshaltern aufliegende Schicht kann auch in erster Linie durch Wärmeleitung temperiert werden. Dazu verfügen die Abstandshalter beispielsweise über eine für eine entsprechende Temperierrate notwendige thermische Leitfähigkeit. Denkbar ist auch, daß der Abstandshalter für die Energieübertragung durch Wärmeleitung eine hohe Absorption für eine elektromagnetische Strahlung einer Energiequelle aufweist, wobei die elektromagnetische Strahlung effizient in thermische Energie umgewandelt wird.

Insbesondere weist der Transparenzkörper eine Vielzahl von Abstandshaltern auf. Bei einer Vielzahl von Abstandshaltern, die gleichmäßig zwischen der Schicht des Mehrschichtkörpers und dem Transparenzkörper berührend angeordnet sind, kann zusätzlich eine Homogenisierung der lateralen Temperaturverteilung erreicht werden.

In einer besonderen Ausgestaltung weist der Transparenzkörper und/oder der Abstandshalter ein Material auf, das aus der Gruppe Glas und/oder Glaskeramik ausgewählt ist. Glaskeramik weist verschiedene Vorteile auf:
- Es kann zum Temperieren in einem weiten Temperaturbereich von beispielsweise 0°C bis z.B. 700°C eingesetzt werden. Glaskeramik weist beispielsweise einen Erweichungspunkt auf, der über dem Temperaturbereich liegt.
- Es verfügt über einen sehr niedrigen thermischen Ausdehnungskoeffizienten. Es ist temperaturschockbeständig und im oben erwähnten Temperaturbereich des Temperierens verwerfungsfrei.
- Es ist gegenüber einer Vielzahl von Chemikalien chemisch inert und weist eine geringe Durchlässigkeit für diese Chemikalien auf. Eine derartige Chemikalie ist beispielsweise das Prozeßgas, dem eine Schicht und/oder der ganze Mehrschichtkörper während des Temperierens ausgesetzt ist.
- Es ist im Spektralbereich vieler Energiequellen für elektromagnetische Strahlung optisch teildurchlässig, insbesondere in einem Wellenlängenbereich, in dem eine Strahlungsdichte der Energiequellen hoch ist. Eine derartige Strahlungsquelle ist beispielsweise eine Halogenlampe mit einer hohen Strahlungsdichte zwischen 0,1 und 4,5 µm.

Glas, insbesondere Quarzglas ist als Material für den Transparenzkörper ebenfalls denkbar. Vorteilhaft daran ist eine hohe Einsatztemperatur von bis zu 1200°C. Diese Materialien zeigen im Spektralbereich einer Energiequelle in Form einer Halogenlampe eine hohe Transmission und eine geringe Absorption. Das Licht tritt im wesentlichen ungehindert durch diesen Transparenzkörper hindurch und gelangt an eine Schicht mit einer entsprechenden Absorption für die elektromagnetische Strahlung, wobei die Schicht eine Energiemenge aufnimmt und erwärmt wird. Der Transparenzkörper wird durch die Strahlung nahezu nicht erwärmt.

In einer Prozeßanwendung ist es möglich, daß Material der erwärmten Schicht verdampft und an einer relativ kalten Oberfläche des Transparenzkörper abgeschieden wird. Um dies zu verhindern, kann dafür gesorgt werden, daß der Transparenzkörper während des Temperierens auf eine nötige Temperatur erwärmt wird. Dies gelingt durch eine Übertragung einer Energiemenge auf den Transparenzkörper durch Wärmeleitung und/oder Konvektion. Denkbar ist auch eine elektromagnetische Strahlung, die der Transparenzkörper absorbiert. Denkbar ist, daß der Transparenzkörper eine Beschichtung aufweist, die einen bestimmten Teil der elektromagnetischen Strahlung absorbiert. Die dadurch aufgenommene Energie kann an den Transparenzkörper aus Glas oder Quarzglas weitergeleitet werden. In dieser Form ist der Transparenzkörper, bestehend aus dem Glaskörper mit der Beschichtung, optisch teildurchlässig und kann sowohl zur Energieübertragung durch Wärmestrahlung als auch durch Wärmeleitung auf den Mehrschichtkörper eingesetzt werden.

In einer besonderen Ausgestaltung steht mindestens eine Schicht des Mehrschichtkörpers mit einem Prozeßgas in Kontakt. Denkbar ist auch, daß der ganze Mehrschichtkörper dem Prozeßgas ausgesetzt ist. Als Prozeßgas kommt beispielsweise ein Inertgas (molekularer Stickstoff oder Edelgas) in Frage. Das Prozeßgas reagiert nicht mit einem Material der Schicht. Denkbar ist aber auch ein Prozeßgas, das mit einem Material der Schicht reagiert. Unter Einwirken des Prozeßgases bildet sich die funktionelle Schicht. Beispielsweise wirkt das Prozeßgas gegenüber einem Material der Schicht oxidierend oder reduzierend. Mögliche Prozeßgase dafür sind Sauerstoff, Chlor, Wasserstoff, elementares Selen, Schwefel oder ein Hydrid. Es kann auch ein ätzendes Prozeßgase wie HCl oder ähnliches sein. Weitere Beispiele für das Prozeßgas sind H₂S und H₂Se, die bei der Herstellung einer Dünnfilmsolarzelle eingesetzt werden (siehe unten). Schließlich sind alle Gase oder auch Gasgemische denkbar, die in einer entsprechenden Weise mit einem Material einer Schicht reagieren.

Vorteilhaft ist es, wenn die Schicht einer definierten Prozeßgasatmosphäre ausgesetzt ist. Die definierte Prozeßgasatmosphäre umfaßt beispielsweise einen Partialdruck des oder der Prozeßgase während des Temperierens. Denkbar ist beispielsweise auch, daß eine Schicht oder der Mehrschichtkörper zum Temperieren mit Vakuum in Kontakt steht.

Eine definierte Prozeßgasatmosphäre läßt sich beispielsweise dadurch erreichen, daß das Prozeßgas mit einer bestimmten Geschwindigkeit an der Schicht vorbeigeleitet wird. Dabei kann ein Prozeßgas mit verschiedenen Partialdrücken im Verlauf des Temperierens auf die Schicht einwirken. Denkbar ist auch, daß nacheinander verschiedene Prozeßgase mit der Schicht des Schichtkörpers in Kontakt stehen.

Vorzugsweise ist zumindest die Schicht umschlossen, die mit dem Prozeßgas in Kontakt steht. Dies gelingt beispielsweise durch eine Umhüllung der Schicht, wobei die Umhüllung an der Trägerschicht befestigt sein kann. Die Umhüllung wird vor oder während des Temperierens mit dem Prozeßgas befüllt. Das Prozeßgas wird dabei auf einer Oberfläche der Schicht konzentriert, deren Eigenschaften durch das Prozeßgas beeinflußt werden soll. Auf diese Weise kann verhindert werden, daß eine Umgebung durch das Prozeßgas kontaminiert wird. Dies ist insbesondere bei einem korrosiven und/oder giftigen Prozeßgas wichtig. Außerdem kann mit einer für eine Umsetzung der Schicht nötigen stöchiometrischen Menge an Prozeßgas gearbeitet werden. Es wird Prozeßgas nicht unnötig verbraucht.

In einer besonderen Ausgestaltung der Erfindung ist der Mehrschichtkörper in einem Temperierbehälter angeordnet. Dabei weist zumindest eine Behälterwandung des Temperierbehälters einen Transparenzkörper auf. Der Temperierbehälter hat den Vorteil, daß er automatisch die Umhüllung des Schicht bzw. den ganzen Mehrschichtkörpers darstellt. Die Umhüllung braucht nicht am Mehrschichtkörper befestigt sein. Bei einem verschließbaren Temperierbehälter kann die Prozeßgasatmosphäre gezielt und leicht eingestellt werden. Beispielsweise bietet der Temperierbehälter ein genügen großes Volumen für das während des Temperierens benötigte Prozeßgas. Wenn das Temperieren eine homogene und reproduzierbare Verteilung des Prozeßgases über einer Schicht erfordert, kann auch gezielt ein Gasaustritt aus dem Temperierbehälter eingestellt werden. Dies kann beispielsweise dann nötig sein, wenn mit einer sehr hohen Aufheizrate temperiert wird. Dabei expandiert das Prozeßgas. Wenn der Temperierbehälter dem dabei auftretenden Gasdruck nicht standhält, kommt es zu einer Verformung des Temperierbehälters oder sogar zur Zerstörung des Temperierbehälters. Eine Verformung sollte aber beispielsweise dann verhindert werden, wenn der Mehrschichtkörper auf dem Boden des Temperierbehälters aufliegt. Ein Verformung des Temperierbehälters kann zu einer lateralen Temperaturinhomogenität im Mehrschichtkörper führen.

Der Temperierbehälter kann zudem Transportmittel des Mehrschichtkörpers beim Temperieren sein. Der Temperierbehälter hat den Vorteil, daß während des Temperierens beispielsweise ein Bruch einer Schicht (Trägerschicht bzw. Substrat) aus Glas nicht ausgeschlossen werden kann. Bei einem Bruch eines solchen Substrats kann das zerbrochene Material leicht aus der Temperiereinheit bzw. aus der Vorrichtung zum Temperieren entfernt werden. Dies trägt zu einer Prozeßstabilisierung des Temperierens bei.

In einer besonderen Ausgestaltung ist die Behälterwandung des Temperierbehälters, die den Transparenzkörper aufweist, ein Deckel und/oder ein Boden des Temperierbehälters. Beipielsweise liegt der Mehrschichtkörper mit einer Schicht direkt auf dem Transparenzkörper des Bodens auf. Der Transparenzkörper kann, wie oben beschrieben, Abstandshalter aufweisen. Der Deckel weist ebenfalls den Transparenzkörper auf, der beispielsweise nicht mit dem Mehrschichtkörper bzw. einer Schicht des Mehrschichtkörpers in Kontakt steht. Auf diese Weise kann die Schicht des Mehrschichtkörpers, die auf dem Boden aufliegt durch Wärmeleitung, die dem Deckel zugewandte Schicht durch Wärmestrahlung aufgeheizt werden. Die dem Deckel zugewandte Schicht kann leicht einem Prozeßgas ausgesetzt sein.

In einer weiteren Ausgestaltung ist der Boden und/oder der Deckel des Temperierbehälters von jeweils mindestens einem Mehrschichtkörper gebildet. Dabei ist die Schicht des Mehrschichtkörpers, die z.B. mit einem Prozeßgas in Berührung kommen soll, in einen Innenraum des Temperierbehälters gerichtet. Diese Lösung ist möglich, wenn der Mehrschichtkörper bzw. die Schichten des Mehrschichtkörpers einen niedrigen Temperaturausdehungskoeffizienten aufweisen und/oder die Temperierrate gering ist. Für eine hohe Temperierrate verfügt der Mehrschichtkörper vorteilhaft über eine Trägerschicht mit einem hohen thermischen Leitfähigkeitskoeffizienten. Die Trägerschicht ist nach außen gerichtet. Beispielsweise ist hier die Trägerschicht ein oben beschriebener Transparenzkörper.

In einer besonderen Ausgestaltung weist der Temperierbehälter, der Transparenzkörper und/oder der Energietransmitter ein Material auf, das gegenüber einem Prozeßgas inert ist. Vorteilhaft ist überdies, daß eine gesamte Prozeßumgebung des Temperierens inert gegenüber dem verwendeten Prozeßgas ist. Zur Prozeßumgebung zählt beispielsweise auch die Energiequelle (primäre Energiequelle).

Das Material wird in Abhängigkeit vom Prozeßgas gewählt. Denkbar ist beispielsweise Glas, Glaskeramik und Keramik. Ein faserverstärktes Material wie kohlefaserverstärkter Graphit kann ebenso verwendet werden. Denkbar ist auch ein Material wie SiC, das einen hohen thermischen Leitfähigkeitskoeffizienten aufweist. Der Temperierbehälter kann aus einem Metall oder einer Legierung bestehen. Ebenso ist ein bis zu einer bestimmten Temperatur beständigen Kunststoff möglich.

Neben einer chemischen Inertheit gegenüber dem Prozeßgas sind folgende Eigenschaften für das Material des Temperierbehälters von Vorteil:
- Das Material des Temperierbehälters ist unter den Bedingungen des Temperierens verwerfungsfrei. Es ist außerdem temperaturschockbeständig. Dies ist insbesondere dann der Fall, wenn es einen geringen Temperaturausdehnungskoeffizienten aufweist.
- Der thermische Erweichungspunkt des Materials des Temperierbehälters liegt über einer maximalen Temperatur des Temperierens.
- Der Temperierbehälter zeigt eine geringe bzw. definierte Permeabilität gegenüber einem Prozeßgas.

In einer besonderen Ausgestaltung ist eine Einrichtung zur Detektion eines Ausmaßes zumindest eines vom Temperieren abhängigen physikalischen Parameters der Vorrichtung und/oder einer Temperiereinheit zur Regelung der ersten und zweiten Teilmenge der Energiemenge vorhanden.

Ein denkbarer Parameter ist eine Absorptions-, Transmissions- und/oder Reflexionseigenschaft einer Schicht. Das Ausmaß des Parameters ist der Wert des Parameters. Beispielsweise kann eine Wellenlänge eines Absorptionsmaximums von der Temperatur abhängen. Das Ausmaß des Parameters wäre in diesem Fall die entsprechende Wellenlänge.

Insbesondere ist der Parameter eine Temperatur des Mehrschichtkörpers. Dabei ist das Ausmaß ein Wert der Temperatur. Denkbar ist auch die Detektion der Temperatur einer Schicht des Mehrschichtkörpers, des Transparenzkörpers und/oder des Temperierbehälters bzw. einer Behälterwandung des Temperierbehälters. Es kann während des Temperierens ständig zumindest ein Parameter des Mehrschichtkörpers und/oder einer Schicht detektiert werden. Beispielsweise wird aufgrund der detektierten Temperatur einer Schicht die Teilmenge der Energiemenge erhöht oder erniedrigt, die von der Schicht aufgenommen wird. Dadurch kann eine Temperaturinhomogenität bzw. ein Temperaturgradient in Dickenrichtung des Mehrschichtkörpers vermieden werden. Diese Temperaturinhomogenität kann aber auch, falls dies nötig sein sollte, erhöht werden.

Beispielsweise ist die Einrichtung zur Detektion der Temperatur ein Pyrometer, der auf die Schicht gerichtet ist. Das Pyrometer detektiert beispielsweise die Wärmestrahlung, die von der Schicht ausgesendet wird. Aufgrund der Wärmestrahlung kann auf die Temperatur der Schicht rückgeschlossen werden. Denkbar ist auch ein Temperaturdetektor, der mit der Schicht verbunden ist und durch Wärmeleitung temperiert wird.

Vorstellbar ist auch, daß die Temperatur der Schicht oder des Mehrschichtkörpers nicht unmittelbar gemessen, sondern mittelbar gemessen wird. Beispielsweise wird ein Pyrometer auf den Temperierbehälter gerichtet, in dem der Mehrschichtkörper temperiert wird. Die Temperatur des Temperierbehälters kann durch die Temperatur des Mehrschichtkörpers beeinflußt sein. Aufgrund der Temperatur des Temperierbehälters wird auf die Temperatur der Schicht des Mehrschichtkörpers rückgeschlossen. Es wird die Energiemenge bzw. die Teilmenge der Energiemenge aufgrund der gemessenen Temperatur des Temperierbehälters geregelt. Dazu ist beispielsweise vor dem Temperieren eine Art "Eichmessung" durchzuführen, die einen Zusammenhang zwischen gemessener Temperatur der Temperierbehälters und tatsächlicher Temperatur der Schicht bzw. des Schichtkörpers wiedergibt. Die "Eichmessung" gibt einen Soll-Wert der Temperatur an. Der Ist-Wert wird detektiert. Ein Vergleich zwischen Soll-Wert und Ist-Wert liefert eine Regelungsgröße zur Regelung der Energiemengen.

Die Detektion (und auch die Regelung der Teilmengen der Energiemenge) erfolgt insbesondere mit einer örtlichen Auflösung in Dickenrichtung des Mehrschichtkörpers und mit einer zeitlichen Auflösung im zeitlichen Rahmen des Temperierens. Beispielsweise wird der Mehrschichtkörper mit einer Temperierrate von 25°C/s aufgeheizt. Dann würden sowohl die Detektion als auch die Regelung der Teilmengen der Energiemenge so schnell stattfinden, daß ein Temperaturunterschied zwischen den Schichten des Mehrschichtkörpers während des Temperierens beispielsweise unter einen vorgeschriebenen Maximum bleibt.

Die Temperaturinhomogenität in Dickenrichtung kann in Verbindung mit einer transienten Verformung des Mehrschichtkörpers auch zu einer lateralen Temperaturinhomogenität im Mehrschichtkörper führen. Lateral bedeutet beispielsweise innerhalb einer Schicht des Mehrschichtkörpers senkrecht zur Dikkenrichtung. Beispielsweise liegt der Mehrschichtkörper auf einem Boden aus Graphit auf. Die Zufuhr bzw. die Aufnahme der Energiemenge durch die auf dem Boden aufliegenden Schicht des Mehrschichtkörpers erfolgt durch Wärmeleitung. Durch eine Temperaturinhomogenität in Dickenrichtung kann eine transiente Verformung des Mehrschichtkörpers in Form einer Verbiegung des Mehrschichtkörpers auftreten. Dabei wird der für die Wärmeleitung notwendige Kontakt zwischen dem Mehrschichtkörper und dem Boden des Temperierbehälters teilweise gelöst. Infolge davon kommt es zu einer lateralen Temperaturinhomogenität der aufliegenden Schicht bzw. des Mehrschichtkörpers. Besonders vorteilhaft ist es daher, wenn zur Detektion des Parameters (und Regelung der Energiemengen) nicht nur in Dickenrichtung, sondern auch lateral eine örtliche Auflösung vorliegt.

In einer besonderen Ausgestaltung ist der Parameter eine Verformung des Mehrschichtkörpers. Aufgrund einer auftretenden Temperaturinhomogenität kann es zu einer Verformung kommen. Beispielsweise wird der Mehrschichtkörper konkav gekrümmt. Der Mehrschichtkörper liegt auf dem Boden beispielsweise eines Temperierbehälters auf. Durch eine konkave Verformung entsteht im Randbereich des Mehrschichtkörpers ein Abstand zwischen der Auflagefläche und dem Mehrschichtkörper. Ein Ausmaß einer derartigen Verformung kann beispielsweise mit einer Einrichtung zur Laserinterferometrie oder Laserlichtreflexion detektiert werden. Aufgrund des Ausmaßes findet die Regelung der Energiemengen statt. Vorteilhaft ist es, wenn das Ausmaß in einem frühen Stadium der Verformung erkannt wird und schnell darauf regiert werden kann.

Für eine angesprochene Einrichtung zur Detektion eines Ausmaßes eine vom Temperieren abhängigen Parameters mit Hilfe einer optischen Einrichtung (z.B. Laser) ist es vorteilhaft, wenn die zu untersuchende Schicht für Licht der optischen Einrichtung zugänglich ist und ein Detektionssignal eindeutig dem zu detektierenden Parameter zuzuordnen ist. Die Wellenlänge eines Lasers sollte sich beispielsweise hinreichend von der Wärmestrahlung des Mehrschichtkörpers unterscheiden. Wenn die Vorrichtung mit einem Temperierbehälter ausgestattet ist, wäre es vorteilhaft, wenn der Transparenzkörper für das Licht des Lasers genügend durchlässig ist.

Mit Hilfe der Vorrichtung ist es auch möglich, eine gewünschte Verformung des Mehrschichtkörpers zu erzielen. Dazu kann es auch sinnvoll sein, die Verformung während des Temperierens wie oben beschrieben zu verfolgen. Es kann zum Beispiel eine gekrümmte Dünnfilmsolarzelle hergestellt werden. Zur gezielten Verformung wird beispielsweise der Mehrschichtkörper auf eine entsprechende Form bzw. Maske gelegt. Die Form bzw. Maske kann direkt eine Energiequelle sein. Der Mehrschichtkörper wird über einen Erweichungspunkt der Trägerschicht erwärmt. Als Folge davon nimmt der Mehrschichtkörper eine entsprechende Form der Maske bzw. der Form an. Die Maske ist beispielsweise in einem Boden des Temperierbehälters integriert. Die Maske könnte z.B. der Transparenzkörper sein.

Zur Lösung der Aufgabe wird neben der Vorrichtung ein Verfahren zum gleichzeitigen Temperieren eines Prozessierguts und mindestens eines weiteren Prozessierguts unter Verwendung der erfindungsgemäßen Vorrichtung angegeben. In dem Verfahren werden das Prozessiergut und mindestens ein weiteres Prozessiergut in den Temperiereinheiten angeordnet und anschließend temperiert.

Insbesondere umfaßt das Temperieren mindestens ein Erhitzen und/oder mindestens ein Abkühlen des Prozessierguts und/oder des weiteren Prozessierguts. Denkbar ist beispielsweise, daß beim Temperieren mehrere Aufheizphasen und mehrere Abkühlphasen durchlaufen werden.

Das Verfahren ist insbesondere dazu geeignet, das Temperieren der Prozessiergüter unter einer Prozeßgasatmosphäre durchzuführen. Dazu wird das erste und/oder das weitere Prozessiergut mit mindestens einem Prozeßgas in Kontakt gebracht. Ein Inkontaktbringen kann vor während oder nach dem Temperieren erfolgen. Eines der Prozessiergüter kann dabei gleichzeitig mit mehreren Prozeßgasen (Gasgemisch) in Kontakt gebracht werden. Denkbar ist auch, daß das Prozessiergut nacheinander mit verschiedenen Prozeßgasen und/oder Spülgasen in Kontakt gebracht wird. So sind ein variables Prozeßgasprofil (zeitliche Abfolge von verschiedenen Partialdrucken des oder der Prozeßgase) möglich. Auf diese Weise ist es beispielsweise möglich, sowohl oxidierende als auch reduzierende Prozeßgase einzusetzen oder gezielt einen Dotierstoff in das Prozessiergut einzubringen.

In einer besonderen Ausgestaltung der Erfindung sind folgende Verfahrensschritte vorgesehen: c) Anordnen des Temperierstapels in einem Hohlraum eines Stapelkorpus, d) Anordnen des Stapelkorpus in einer Temperierkammer in einem Abstand zur Temperierkammer, so daß zwischen dem Stapelkorpus und der Temperierkammer ein Zwischenraum entsteht, und e) Herstellen eines Gasdrucks eines Spülgases in dem Zwischenraum. Diese Verfahrensschritte finden vor dem Temperieren statt. Der Zwischenraum mit dem Spülgas fungiert als Puffer, so daß das Prozeßgas, das sich im Hohlraum befindet, nicht oder nur verdünnt an die Temperierkammer gelangt. Eine Kontamination bzw. Korrosion der Temperierkammer kann unterbunden werden. Die Auswahl des Materials der Temperierkammer ist nahezu unabhängig von dem Prozeßgas. Der Zwischenraum kann einmalig mit dem Spülgas befüllt werden. Denkbar ist auch, daß durch den Zwischenraum ein kontinuierlicher Spülgasstrom geleitet wird, der eventuell aus dem Stapelkorpus austretendes Prozeßgas aus dem Zwischenraum entfernt. Ein Entfernen austretenden Prozeßgases gelingt auch dadurch, daß vom Hohlraum des Stapelkorpus zum Zwischenraum hin ein Druckgefälle erzeugt wird.

In einer besonderen Ausgestaltung der Erfindung wird im Zwischenraum zwischen Temperierkammer und dem Stapelkorpus ein Gasdruck eines Spülgases erzeugt, der größer ist als der Gasdruck im Stapelkorpus. Vorzugsweise sind dazu im Stapelkorpus Gasausauslaßöffnungen angebracht, die beispielsweise über eine Sammelrohrleitung durch den Zwischenraum und durch die Temperierkammer nach außen geführt sind und dort beispielsweise in eine Gasentsorgungseinheit geleitet werden. Somit herrscht in dem Hohlraum des Stapelkorpus annähernd der Druck, der auch in der Gasentsorgungseinheit vorhanden ist (z.B. Atmosphärendruck). Die Wirkung dieser Anordnung kann als Spaltgegenstrom-Spülung bezeichnet werden, die dazu dient, an einem Spalt einer Durchführung des Stapelkorpus, beispielsweise an einer Umhüllung einer Energiequelle, oder an einer Fügespalte eines Bauteils des Stapelkorpus einen Inertgasgegenstrom gegen den ausdiffundierenden Prozeßgasstrom gegenzuhalten mit dem Ziel, eine Kondensation von Prozeßgasen an den Temperierkammerwänden oder eine Korrosion der Temperierkammerwände zu verhindern. Letzteres kann übrigens auch durch eine geeignete Beschichtung der Temperierkammerwände erreicht werden.

Die Spaltgegenstrom-Spülung gelingt nach folgendem Prinzip: Im Stapelkorpus sind die mit dem Prozeßgas befüllten Temperierbehälter angeordnet. Es kann nicht ausgeschlossen werden, daß das Prozeßgas in den Hohlraum des Stapelkorpus gelangt. Durch kleine Spalte oder Öffnungen stehen der Hohlraum des Stapelkorpus und der Zwischenraum zwischen Stapelkorpus und Temperierkammer in Verbindung. Durch die Wahl der Gasdrucke wird ein Druckgradient von dem Zwischenraum zum Hohlraum des Stapelkorpus aufgebaut. Dies gelingt beispielsweise durch Absaugen des Spülgases des Hohlraums und/oder Einleiten des Spülgases in den Zwischenraum und einem dadurch hervorgerufenem Druckaufbau gegenüber dem Druck des Hohlraums, der wie oben beschrieben mit der Umgebung der Vorrichtung zum Temperieren in Kontakt stehen kann. Dadurch kommt es zu einem Spülgasstrom von Zwischenraum zum Hohlraum hin. Das Prozeßgas gelangt nicht an die Kammerwandung der Temperierkammer. Während des Temperierens wird dabei insbesondere eine Temperatur der Temperierkammer, der Gasdruck des Hohlraums und/oder der Gasdruck des Zwischenraums eingestellt.

In einer besonderen Ausgestaltung der Erfindung wird als Prozessiergut und/oder weiteres Prozessiergut ein Mehrschichtkörper mit einer Schicht und mindestens einer weiteren Schicht verwendet.
Dabei erfolgt das Temperieren durch Aufnahme einer Energiemenge durch den Mehrschichtkörper mit einer Aufnahme einer ersten Teilmenge der Energiemenge durch die erste Schicht und einer Aufnahme einer zweiten Teilmenge der Energiemenge durch die zweite Schicht, wobei zumindest eine Energiequelle zum Zuführen der Energiemenge auf den Mehrschichtkörper verwendet wird. Dabei wird insbesondere eine zuvor beschriebene Vorrichtung verwendet. Die Verfahrensschritte sind: Anordnen des Mehrschichtkörpers zwischen einer ersten und mindestens einer zweiten Energiequelle, so daß die erste Schicht zwischen der ersten Energiequelle und der zweiten Schicht und die zweite Schicht zwischen der zweiten Energiequelle und der ersten Schicht angeordnet ist, wobei als Energiequelle zumindest eine Energiequelle für eine bestimmte elektromagnetische Strahlung mit einem Strahlungsfeld verwendet wird, und zumindest eine der Schichten die elektromagnetische Strahlung absorbiert und im Strahlungsfeld der Energiequelle angeordnet wird, und Anordnen eines Transparenzkörpers im Strahlungsfeld der Energiequelle zwischen der Energiequelle und der Schicht, die im Strahlungsfeld der Energiequelle liegt und die die bestimmte elektromagnetische Strahlung absorbiert und Temperieren des Mehrschichtkörpers.

In einer besonderen Ausgestaltung absorbiert der Transparenzkörper eine bestimmte Energiemenge und führt die Energiemenge der Schicht zu. In einer weiteren Ausgestaltung wird während des Temperierens ein Detektieren eines vom Temperieren abhängigen Ausmaßes eines physikalischen Parameters des Mehrschichtkörpers zur Regelung der Aufnahme der Energiemenge während des Temperierens und Regelung der ersten und zweiten Teilmengen der Energiemenge durchgeführt. In einer besonderen Ausgestaltung führt der Transparenzkörper die Schicht die Energiemenge durch Wärmeleitung und/oder Wärmestrahlung zu.

In einer besonderen Ausgestaltung wird ein Mehrschichtkörper mit einer Schicht verwendet, die Kupfer, Indium, Gallium und/oder Selen aufweist. Insbesondere wird ein Mehrschichtkörper mit einer Trägerschicht aus Glas und/oder Metall verwendet. Die Trägerschicht kann ihrerseits eine Beschichtung aufweisen (z.B. eine Metallschicht auf einer Glasplatte). Als Prozeßgas wird ein Gas verwendet, das aus der Gruppe H₂S, H₂Se, H₂, He und N₂ ausgewählt ist. Das Verfahren dient insbesondere der Herstellung eines photovoltaischen Dünnschicht-Chalkopyritabsorbers einer Solarzelle und/oder eines Solarmoduls. Bei dem Solarmodul ist eine Vielzahl von seriell verschalteten einzelnen Solarzellen vorhanden. Das Glas ist vorzugsweise Sodalime-Glas. Die entsprechende Schicht fungiert als Trägerschicht. Auf der Trägerschicht ist eine Molybdänschicht als Elektrode und über der Molybdänschicht eine funktionelle Schicht, nämlich eine Kupfer-Indium-Gallium-Sulfo-Selenid(CIGSSe)-Halbleiterschicht, aufgetragen. Eine Dicke des Schichtkörpers, bestehend Glaskörper und Halbleiterschicht beträgt typischerweise 2 bis 4 mm, mit einer Molybdänschicht von ca. 0,5 µm und einer Halbleiterschicht von ca. 3 µm. Der angegebene Bereich für die Dicke des Mehrschichtkörpers ist nicht ausschließend zu verwenden. Begrenzender Faktor ist eine Fähigkeit, ein großes Substrat herzustellen, das möglichst plan ist und damit mit der beschriebenen Vorrichtung bzw. mit dem beschriebenen Verfahren zu einem Mehrschichtkörper verarbeitet werden kann.

Zusammengefaßt ergeben sich mit der Erfindung folgende Vorteile:
- Es können gleichzeitig mehrere Prozessiergüter unter wechselnder Prozeßgasatmosphäre temperiert werden. Dabei kann ein Aufheiz- und/oder Abkühlprofil des Temperierens variabel gestaltet werden.
- Es kann ein Prozessiergut in Form eines großflächigen Mehrschichtkörper mit einem unsymmetrischen Schichtaufbau (z.B. Mehrschichtkörper mit einer einzigen Schicht auf einer Trägerschicht) mit einer hohen Temperierrate von über 1°C/s temperiert werden.
- Die Schichten des Mehrschichtkörpers können dabei einen stark unterschiedlichen thermischen Leitfähigkeitskoeffizienten und/oder ein stark unterschiedliches Emissionsvermögen aufweisen.
- Durch eine zeitliche und örtliche Auflösung der Detektion und der Regelung eines Ausmaßes eines vom Temperieren abhängigen Parameters gelingt ein Temperieren besonders sicher. Beispielsweise kann auf eine Änderung einer Eigenschaft des Prozessierguts (z.B. Emissions- oder Absorptionsvermögen) während des Temperierens reagiert und die Prozeßparameter (Druck, Temperatur, Energiedichte, etc.) daraufhin eingestellt werden.
- Das Temperieren bis nahe eines Erweichungspunkts einer Trägerschicht ist möglich.
- Ein schnelles Temperieren von 1°C/s bis hin zu 100°C/s ist möglich. Dabei können Temperaturen von z.B., 1100°C erreicht werden.
- Beim Temperieren über den Erweichungspunkt der Trägerschicht ist eine permanente Verformung des Mehrschichtkörpers möglich.
- Es kann eine definierte Temperierungsumgebung mit einer definierten Prozeßgasatmosphäre geschaffen werden. Verschiedene Prozeßgase mit verschiedenen Partialdruckprofilen können gleichzeitig oder nacheinander vor, während und/oder nach der Prozessierung eingestellt werden. Insbesondere kann ein toxisches und/oder korrosives Prozeßgas eingesetzt werden. Kondensationen einer Prozeßsubstanz an den Kammerwänden kann vermieden werden.
- Alle zur Prozessierung notwendigen Verfahrensstufen können mit einer einzigen Vorrichtung durchgeführt werden.

Anhand mehrerer Ausführungsbeispiele und der dazugehörigen Figuren wird eine Vorrichtung zum Temperieren eines Prozessierguts und ein entsprechendes Verfahren dazu vorgestellt. Die Figuren sind schematisch und stellen keine maßstabsgetreuen Abbildungen dar.
- Figur 1: zeigt einen Querschnitt einer Vorrichtung zum Tem- perieren von mindestens einem Prozessiergut von der Seite.
- Figuren 2a bis 2f: zeigen mögliche Ausgestaltungen der Temperiereinheit.
- Figur 3: zeigt einen Ausschnitt des Temperierstapels, wobei die Prozessiergüter zweier Temperiereinheiten über Durchlaßöffnungen miteinander verbunden sind.
- Figur 4: zeigt einen geschlossenen, evakuierbaren und mit Gas befüllbaren Stapelkorpus.
- Figur 5: zeigt einen Stapelkorpus, der in einer evakuierbaren Temperierkammer angeordnet ist.
- Figuren 6a bis 6c: zeigen eine Energiequelle, die in einer Umhüllung angeordnet ist.
- Figuren 7a bis 7c: zeigen verschiedene Ausführungsformen der Reflexionskörper.
- Figur 8: zeigt einen Querschnitt einer bestimmten Vorrichtung zum Temperieren.
- Figur 9: zeigt einen Längsschnitt der bestimmten Vorrichtung zum Temperieren.
- Figur 10: zeigt einen Ausschnitt des Längsschnitts der bestimmten Vorrichtung zum Temperieren.
- Figur 11: zeigt ein Verfahren zum Temperieren mehrerer Prozessiergüter.
- Figur 12: zeigt einen Querschnitt durch eine Ausführungsform zur Prozessierung mehrerer Prozessiergüter an unter Verdeutlichung des Prinzips der Gasgegenstrom- Spülung

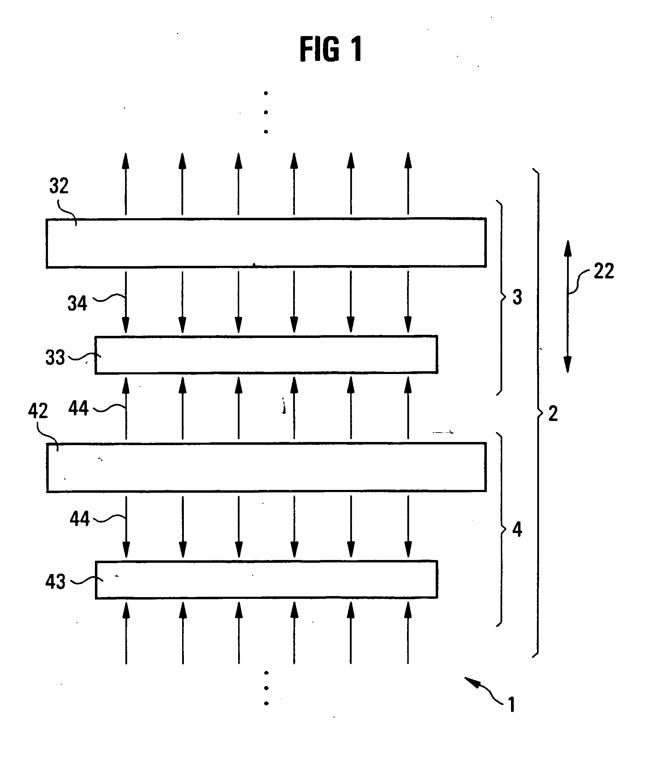

Ausgangspunkt ist eine Vorrichtung 1 zum Temperieren mehrerer Prozessiergüter 33 und 43 (Figur 1). Die Vorrichtung besteht aus mehreren übereinander zu einem Temperierstapel 2 angeordnete Temperiereinheiten 3 und 4. Eine Temperiereinheit 3 bzw. 4 weist eine Energiequelle 32 bzw. 42 auf. Zum Temperieren der Prozessiergüter sind die Energiequellen und die Prozessiergüter derart aneinander angeordnet, daß in einer bestimmten Stapelrichtung 22 des Temperierstapels 2 zwischen der Energiequelle 32 und der weiteren Energiequelle 42 das Prozessiergut 33 und zwischen dem Prozessiergut 33 und dem weiteren Prozessiergut 43 die weitere Energiequelle 42 angeordnet sind.

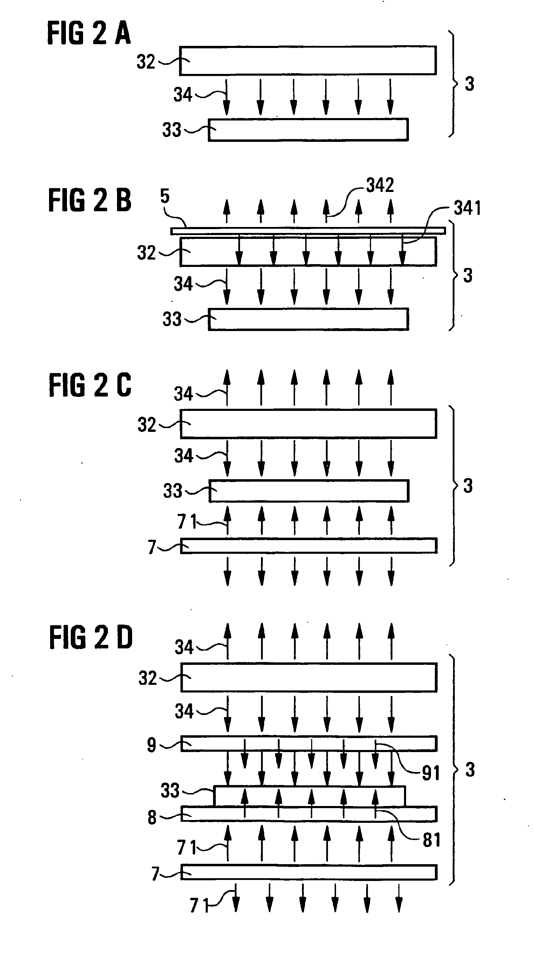

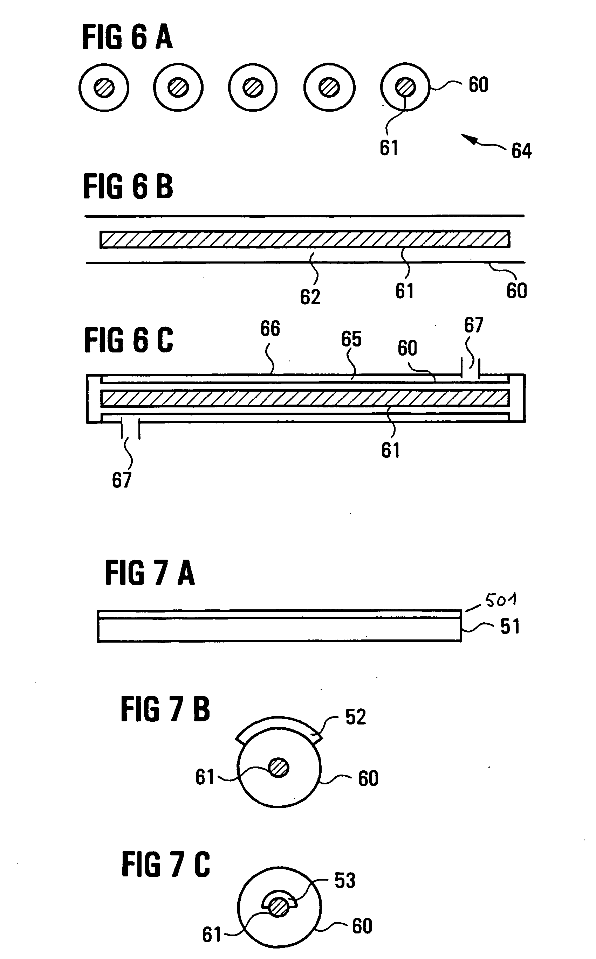

Die Energiequellen 32 bzw. 42 sind in einer Ausführung stabförmige Halogenlampen 61, die in Form eines Arrays 64 angeordnet sind (Figur 6). Jede der Halogenlampen 61 des Arrays 64 ist in eine Umhüllung 60 aus Quarzglas angeordnet. Der Zwischenraum zwischen Umhüllung 60 und Halogenlampe 61 ist von einem flüssigen oder gasförmigen Kühlmittel 62 durchflossen. Die Halogenlampen 61 senden beim Temperieren eine elektromagnetische Strahlung 34 bzw. 44 in Form von Infrarotstrahlung aus, die von den Prozessiergütern 33 bzw. 43 zur Aufnahme eine entsprechenden Energiemenge absorbiert wird. Dazu sind die Prozessiergüter 33 und 43 in den Strahlungsfeldern der Energiequellen 32 bzw. 42 angeordnet. In einer ersten Ausführungsform ist das Prozessiergut 33 einer Temperiereinheit 3 nur dem Strahlungsfeld 34 der Energiequelle 32 der Temperiereinheit 3 ausgesetzt (Figur 2a). In einer weiteren Ausführungsform ist das Prozessiergut 33 zusätzlich im Strahlungsfeld 44 der Energiequelle 42 einer benachbarten Temperiereinheit 4 angeordnet (Figur 1). In einer nächsten Ausführungsform ist ein Reflexionskörper 5 angeordnet zur Formung des Strahlungsfeldes (Figur 2b). Der Reflexionskörper 5 besteht aus einer Aluminiumoxidbeschichtung 501 auf einem Trägerkörper 51 aus Glaskeramik (Figur 7a). Der Reflexionskörper 5 reflektiert auf der Aluminiumoxidbeschichtung 501 auftreffende elektromagnetische Strahlung 341 in Richtung des entsprechenden Prozessierguts 33.

In den Figuren 7b und 7c sind zwei weitere Lösungen für die Gestaltung des Reflexionskörpers 5 gezeigt. Der Reflexionskörper 52 ist gemäß Figur 7b ein Teil der Umhüllung 60 der Energiequelle 61. Nach Figur 7c ist der Reflexionskörper 53 direkt an einer Quarzglasumhüllung der Halogenlampe 61 angeordnet.

In einer weiteren Ausführung ist der Reflexionskörper 5 teildurchlässig für die elektromagnetische Strahlung 34, so daß in einen benachbarten Halbraum ein Teil der Strahlung 342 abgegeben wird (Figur 2b).

In einer Ausführungsform sind die Umhüllungen 60 beidseitig offen (Figur 6b). Zum Kühlen wird ein Kühlmittel 62 in Form eines Kühlgases durch die Umhüllung 60 gepumpt. In einer weiteren Ausführungsform ist die Umhüllung 60 ergänzt durch eine Ummantelung 66 (Figur 6c). Der dadurch erzeugte Zwischenraum zwischen Ummantelung 66 und Umhüllung 60 ist mit Zufluss und Abfluss 67 versehen und zum Kühlen von einer Kühlflüssigkeit 65 durchströmt.

Gemäß Figur 2c verfügt die Temperiereinheit über eine zusätzliche Energiequelle 7 mit einer zusätzlichen elektromagnetischen Strahlung 71, der das Prozessiergut 33 ausgesetzt ist. Nach Figur 2d sind in der Strahlungsfeldern der Energiequelle 32 und der zusätzlichen Energiequelle 7 jeweils ein Transparenzkörper 8 und 9 angeordnet. Die Transparenzkörper 8 und 9 sind Glaskeramikplatten, die für die elektromagnetische Strahlung 34 und die zusätzliche elektromagnetische Strahlung 71 semitransparent sind. Auf einem Transparenzkörper 8 liegt das Prozessiergut 33 auf. Ein Teil der elektromagnetischen Strahlung 71 wird von diesem Transparenzkörper 8 absorbiert und in Form von Wärmeleitung 81 an das Prozessiergut 33 weitergeleitet.

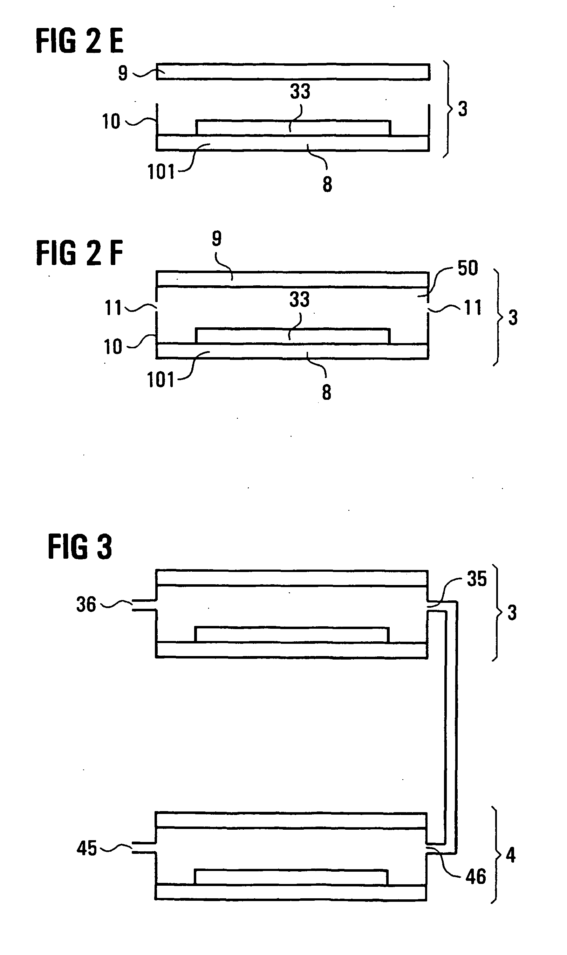

Weitere Ausführungsformen sind in der Figuren 2e und 2f zu sehen. Nach Figur 2e weist die Temperiereinheit 3 einen offenen Temperierbehälter 10 auf, in dem das Prozessiergut 33 angeordnet ist. Eine Behälterwandung 101 des Temperierbehälters 10 weist einen Transparenzkörper 8 auf. Die Behälterwandung 101 ist der Boden des Temperierbehälters 10. Der Temperierbehälter 10 ist gemäß Ausführungsform nach Figur 2f verschließbar. Zum Evakuieren und Befüllen des Temperierbehälters 10 mit Prozeßgas verfügt der Temperierbehälter 10 über verschließbare Öffnungen (Gasöffnungen) 11, die als Ventile ausgeführt sind. Alternativ dazu sind die Ventile selbstschließend (Rückschlag-Ventile).

Figur 3 zeigt eine Möglichkeit, wie die Temperierbehälter 10 zweier Temperiereinheiten 3 und 4 mit dem Prozeßgas 12 gemeinsam beaufschlagt werden können. Dabei sind die Temperierbehälter 10 über die Gasein- und Auslässe 35, 36, 45 und 46 miteinander verbunden. In einer anderen Ausführungsform wird jeder Temperierbehälter 10 separat mit Prozeßgas 12 befüllt.

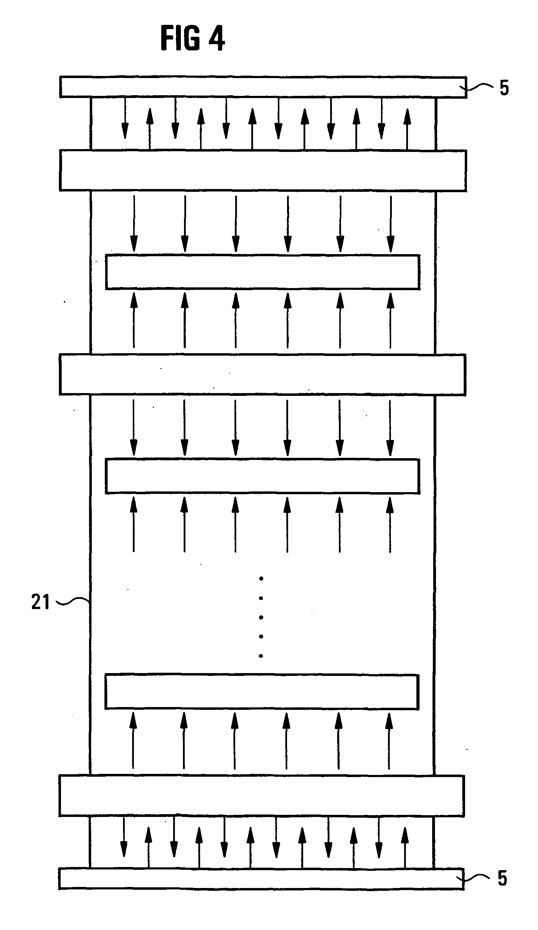

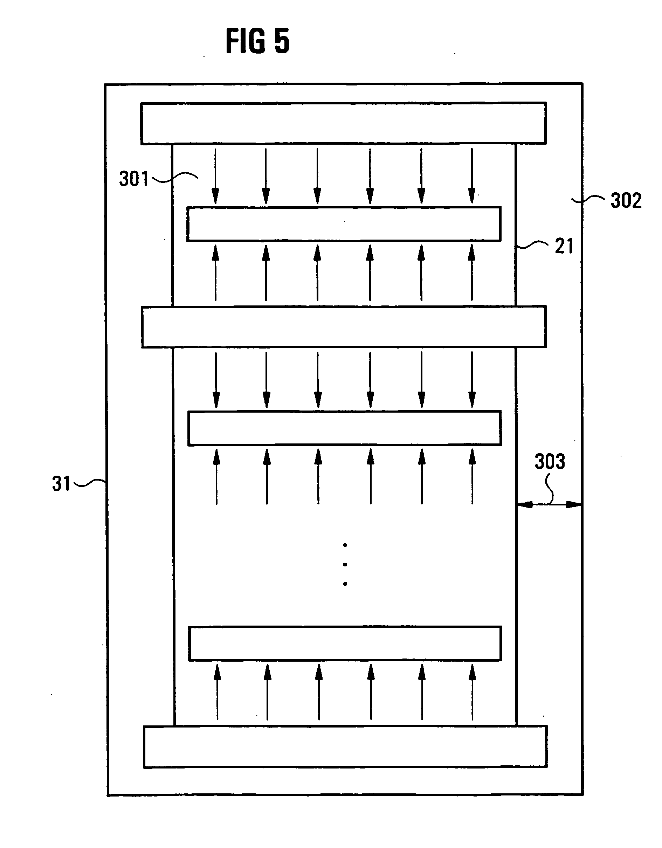

Figur 4 zeigt einen Temperierstapel 2, dessen Stapelwandungen teilweise von den Korpuswandungen des Stapelkorpus 21 gebildet sind. Zusätzliche Wandungen sind durch Reflexionskörper 5 in Form von Reflektorplatten (Figur 7a) gegeben. Dieser Temperierstapel 2 ist in einer weiteren Ausführungsform in einer evakuierbaren Temperierkammer 31 mit einem Abstand 303 angeordnet (Figur 5).

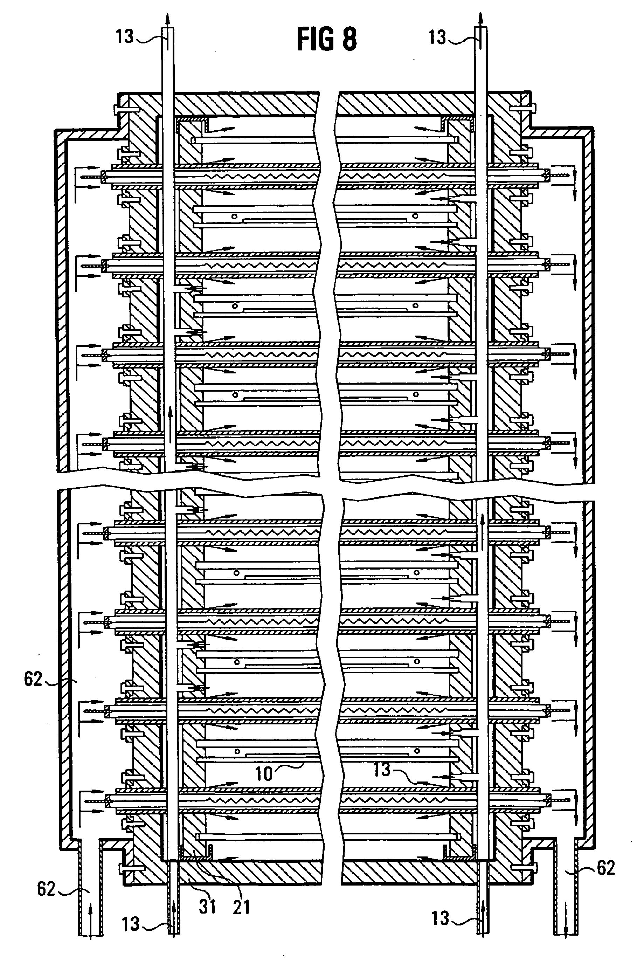

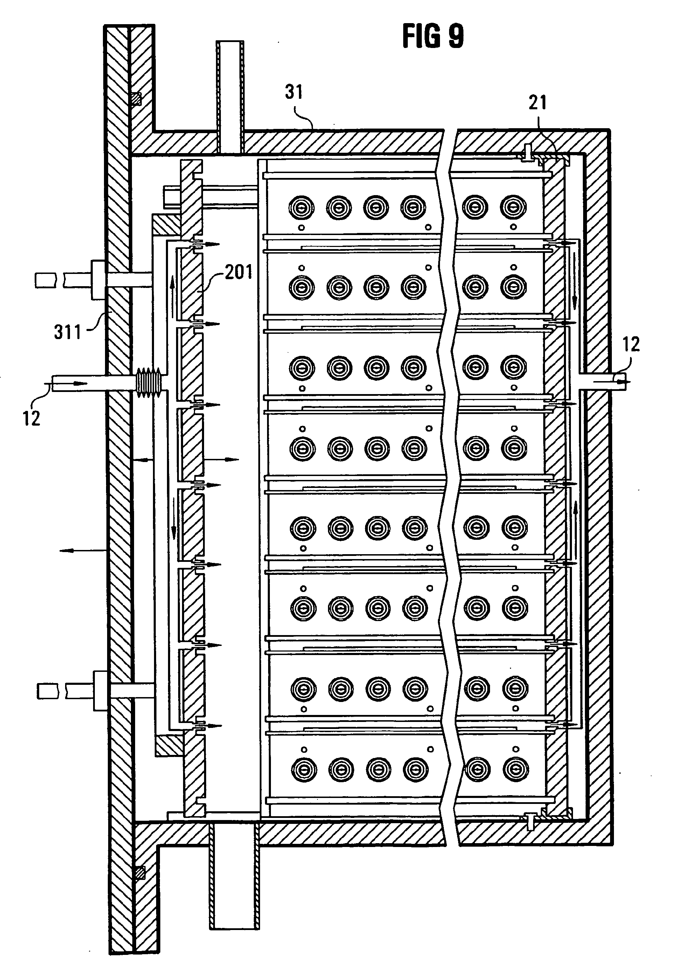

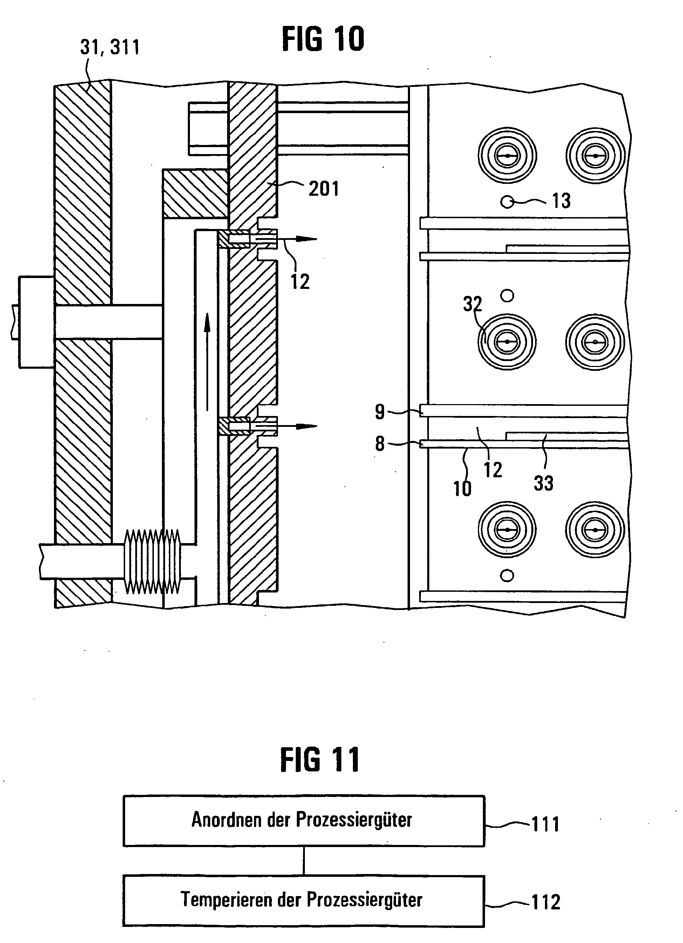

Eine spezielle Ausführungsform ist in den Figuren 8 bis 10 gezeigt. Jede der Temperiereinheiten 3 und 4 des Temperierstapels 2 ist so aufgebaut, wie in Figur 2d dargestellt, wobei keine der Temperiereinheiten 3 und 4 eine zusätzliche Energiequelle 7 aufweist. Die Energiequellen 32 und 42 sind Arrays 64 von stabförmigen Halogenlampen 61. Den oberen und unteren Abschluß des Temperierstapels 2 bildet jeweils ein plattenförmiger Reflexionskörper 5 mit zum Temperierstapel 2 hin angeordnetem Array 64 von Halogenlampen 61 als Energiequelle. Die Transparenzkörper 8, 9 in Form von Glaskeramikplatten sind in Nuten des Stapelkorpus 21 eingeschoben.

Jeweils ein Temperierbehälter 10 wird gebildet aus zwei Transparenzkörpern 8 und 9 und der Korpuswandung des Stapelkorpus 21. Die Temperierbehälter 10 verfügen über Öffnungen 11 zum Herstellen einer bestimmten Gasatmosphäre in den Temperierbehältern 3 und 4 (Figur 2F).

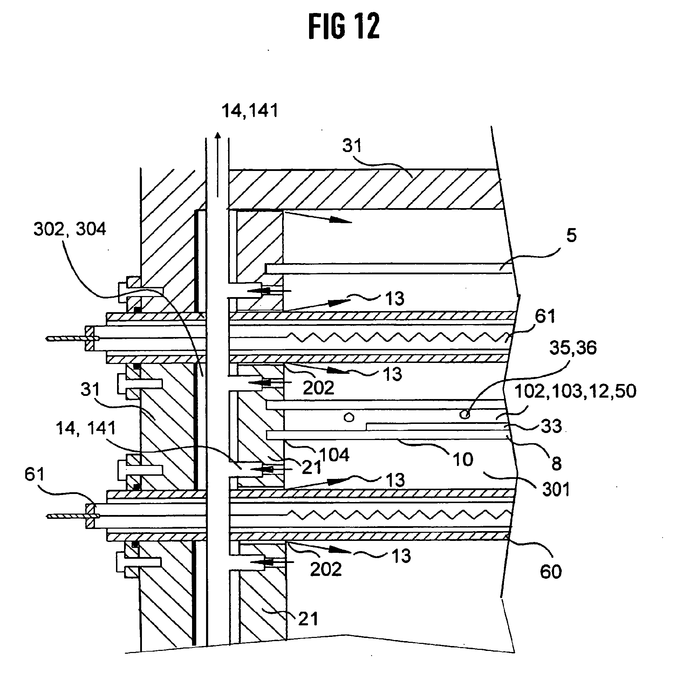

Figur 12 zeigt einen Ausschnitt aus der Figur 8 zur Verdeutlichung der Spaltgegenstrom-Spülung. Durch die Pfeile ist ein Druckgradient bzw. ein sich daraus ergebender Gasstrom 13 angedeutet. Während des Temperierens herrscht in einem Behälterinnenraum 102 eines Temperierbehälters 10 eine Gasatmosphäre 50 des Prozeßgases 12 mit einem bestimmten Gasdruck 103. Durch einen Spalt 104 des Temperierbehälters 10 kann das Prozeßgas 12 in den Hohlraum 301 des Stapelkorpus 21 austreten. Um zu verhindern, daß die Kammerwandung im Inneren der Temperierkammer 31 durch das Prozeßgas 12 kontaminiert wird, ist der Hohlraum 301 mit einer Umgebung 14 verbunden, in der ein Gasdruck 141 herrscht, der kleiner ist als der Gasdruck 103 im Behälterinnenraum 102 der Temperierkammer 31. Gleichzeitig wird dafür gesorgt, dass im Zwischenraum 302 zwischen der Kammerwandung der Temperierkammer 31 und der Korpuswandung des Stapelkorpus 21 ein Gasdruck 304 herrscht, der in etwa dem Gasdruck 103 entspricht, der im Behälterinnenraum 102 des Temperierbehälters 10 herrscht. Er ist etwas größer, so daß das Prozeßgas 12 durch einen Spalt 202 des Stapelkorpus 21 nicht in den Zwischenraum 302 gelangt. Dadurch, daß in der Umgebung 14 der im Vergleich zu den Drucken 103 und 304 kleinere Gasdruck 141 herrscht, wird eventuell in den Hohlraum 301 des Stapelkorpus 21 austretendes Prozeßgas 12 aufgrund der herrschenden Druckgradienten in Richtung Umgebung 14 transportiert. Im Falle von toxischen Prozeßgasen oder Dämpfen werden diese durch zwischengeschaltete Entsorgungseinheiten wie z.B. Naßwäscher oder Kühlfallen entsorgt. In die Umgebung 14 werden dann beispielsweise nur noch unbedenkliche Trägergase entlassen.

Der Stapelkorpus 21 ist in einer Temperierkammer 31 eingesetzt. Der Stapelkorpus 21 verfügt über eine Tür 201, die unabhängig von der Tür 311 der Temperierkammer 31 geöffnet werden kann. Die Tür stellt gleichzeitig eine Behälterwandung der Temperierbehälter dar.

Folgender Ablauf eines Verfahrens zum Temperieren wird beispielhaft angegeben:
- Beladen des Stapelkorpus mit den Prozessiergütern (111)
- Schließen der Temperierkammer.
- Mehrmaliges Abpumpen und Befüllen der Temperierbehälter mit Inertgas bei offenem Stapelkorpus.
- Schließen des Stapelkorpus und damit Schließen der Temperierbehälter
- Öffnen von Spülgas-Einlaß und Auslaß zur Spaltgegenstrom-Spülung.
- Öffnen von Prozeßgas-Einlaß- und Auslaß in die Temperierbehälter und Durchführung des gewünschten Prozeßgas-Partialdruckprofiles.
- Einstellen eines geringen Kühlluft-Stromes durch die Umhüllungen der Energiequellen.
- Temperieren (112): Einschalten der Energiequellen und Regeln der Heizerarrays nach einem gewünschten Temperaturprofil. Regeleingangsgröße ist das Signal von Thermoelementen, die in einer Ausführungsform an den Temperierbehältern 10 angebracht sind.
- Anschalten oder Herunterregeln der Energiequellen 32, 42 und 7 und Steuerung des Abkühlprofils durch Regelung des Kühlluft-Stromes.
- Einbringen eines Spülgases in die Prozeßgas-Einlässe
- Öffnen des Stapelkorpus und mehrmaliges Abpumpen und Befüllen mit Inertgas.
- Öffnen der Temperierkammer und Entladen der Prozessiergut.

In einer Ausführungsform wird beim Temperieren eine Ober- und Unterhitze eines Prozessierguts separat angesteuert. Dies ist aber nur möglich mit jeweils separat ansteuerbaren Energiequellen, zwischen denen sich das Prozessiergut befindet. Folgende alternative Lösungen bestehen für den Fall, daß im Temperierstapel jeweils eine Energiequelle für einen Prozessiergut vorgesehen ist und daß während des Temperierens ein fest eingestelltes Verhältnis von Ober- zu Unterhitze tolerierbar ist:
- Boden und Deckel des Temperierbehälters 10 bestehen aus verschieden Infrarot-durchlässigem Material. Der Deckel ist aus Infrarot-teilabsorbierender Glaskeramik. Der Boden weist ein Graphit auf. In einer anderen Ausführungsform ist der Deckel aus Quarzglas und der Boden aus Keramik.
- Boden und Deckel des Temperierbehälters bestehen aus dem gleichen Material, haben aber eine unterschiedliche optische Dichte bezüglich der Infrarotstrahlung und unterschiedliche Dicken von Boden und Deckel.
- Die Energiequellen sind halbseitig mit Infrarot-Teilreflektoren beschichtet.
- Die Umhüllungen sind halbseitig mit Infrarot-Teilreflektoren beschichtet.
- Verwendung von Reflexionskörper zwischen den Temperiereinheiten.

## Patentansprüche

1. Vorrichtung zum gleichzeitigen Temperieren mehrerer Prozessiergüter (33, 43) in einer bestimmten Gasatmosphäre (50) durch Aufnahme einer Energiemenge durch ein Prozessiergut (33, 43) mittels Absorption einer bestimmten elektromagnetischen Strahlung (34, 44) und durch Aufnahme mindestens einer weiteren Energiemenge durch mindestens ein weiteres Prozessiergut (43, 33) mittels Absorption mindestens einer weiteren bestimmten elektromagnetischen Strahlung (44, 34) wobei die Vorrichtung
- eine Temperiereinheit (3) mit mindestens einer Energiequelle (32) zur Erzeugung der elektromagnetischen Strahlung (34) und
- mindestens eine weitere Temperiereinheit (4) mit mindestens einer weiteren Energiequelle (42) zur Erzeugung der weiteren elektromagnetischen Strahlung (44) aufweist, wobei
- die Temperiereinheiten (3, 4) einen offenen Temperierbehälter (10) aufweisen, in dem das Prozessiergut (33, 43) angeordnet ist und die Temperierbehälter (10) über verschließbare Gasöffnungen (11) zum Evakuieren und Befüllen der Temperierbehälter (10) mit Prozessgas verfügen, wobei
- die Temperiereinheiten (3, 4) übereinander zu einem Temperierstapel (2) angeordnet sind, so dass
- in einer bestimmten Stapelrichtung (22) des Temperierstapels (2) zwischen der Energiequelle (32) der Temperiereinheit (3) und der weiteren Energiequelle (42) der weiteren Temperiereinheit (4) das Prozessiergut (33) und zwischen dem Prozessiergut (33) und dem weiteren Prozessiergut (43) die weitere Energiequelle (42) angeordnet ist und wobei
- die Gasöffnungen (11) der Temperierbehälter (10) so miteinander verbunden sind, dass eine gemeinsame Prozessgasatmosphäre in den Temperierbehältern (10) geschaffen wird.

2. Vorrichtung nach Anspruch 1, wobei zumindest eine der Temperiereinheiten (3, 4) zumindest eine zusätzliche Energiequelle (7) aufweist zur Erzeugung einer zusätzlichen Energiemenge und zur Aufnahme der zusätzlichen Energiemenge durch das Prozessiergut der Temperiereinheit.

3. Vorrichtung nach Anspruch 1 oder 2, wobei zumindest eine der Temperiereinheiten zumindest einen Reflexionskörper (5) aufweist zur Formung eines Strahlungsfeldes zumindest einer der elektromagnetischen Strahlungen.

4. Vorrichtung nach Anspruch 3, wobei der Reflexionskörper (5) für zumindest eine der elektromagnetischen Strahlungen teildurchlässig ist.

5. Vorrichtung nach einem der Ansprüche 1 bis 4, wobei zumindest eine der Temperiereinheiten mindestens ein Mittel (62) zum Kühlen des Prozessierguts aufweist.

6. Vorrichtung nach einem der Ansprüche 1 bis 5, wobei zumindest eine der Energiequellen in einer Umhüllung (60) angeordnet ist, die für die elektromagnetische Strahlung der Energiequelle zumindest teilweise transparent ist.

7. Vorrichtung nach Anspruch 6, wobei die Umhüllung (60) der Energiequelle das Mittel zum Kühlen (62) aufweist.

8. Vorrichtung nach Anspruch 6 oder 7, wobei die Umhüllung (60) der Energiequelle den Reflexionskörper (52) aufweist.

9. Vorrichtung nach einem der Ansprüche 1, bis 8, wobei zumindest eine der Temperiereinheiten (3, 4) ein Temperierbehälter (10) mit einer Behälterwandung aufweist.

10. Vorrichtung nach einem der Ansprüche 1 bis 9, wobei der Temperierstapel (2) einen Stapelkorpus (21) mit einer Korpuswandung aufweist.

11. Vorrichtung nach einem der Ansprüche 1 bis 10, wobei der Temperierstapel (2) und/oder der Stapelkorpus (21) in einer Temperierkammer (31) mit einer Kammerwandung angeordnet sind.

12. Vorrichtung nach Anspruch 10 oder 11, wobei der Stapelkorpus und/oder die Temperierkammer temperierbar sind.

13. Vorrichtung nach Anspruch 11 oder 12, wobei die Temperierkammer (31) mit einer vakuumdichten Türe (311) versehen ist, an der im Inneren der Temperierkammer (31) eine Tür (201) des Stapelkorpus (21) angeordnet ist, die unabhängig von der Tür (311) der Temperierkammer (31) geöffnet und geschlossen werden kann.

14. Vorrichtung nach einem der Ansprüche 1 bis 13, wobei zumindest eines der Prozessiergüter ein Mehrschichtkörper mit zumindest einer Schicht ist, die eine bestimmte Absorption zumindest einer der elektromagnetischen Strahlungen aufweist.

15. Vorrichtung nach einem der Ansprüche 1 bis 14, wobei zumindest eine der Temperiereinheiten zumindest einen Transparenzkörper (8, 9) aufweist, der eine bestimmte Absorption und eine bestimmte Transmission für zumindest eine der elektromagnetischen Strahlungen aufweist und der im Strahlungsfeld der elektromagnetischen Strahlung zwischen der Energiequelle der elektromagnetischen Strahlung und einem der Prozessiergüter angeordnet ist.

16. Vorrichtung nach Anspruch 15, wobei die Umhüllung der Energiequelle, der Temperierbehälter, der Stapelkorpus, die Temperierkammer, der Transparenzkörper und/oder der Reflexionskörper ein Material aufweisen, das gegenüber dem Gas (12) inert ist.

17. Verfahren zum gleichzeitigen Temperieren eines Prozessierguts (33) und mindestens eines weiteren Prozessierguts (43) unter der Verwendung der Vorrichtung nach einem der Ansprüche 1 bis 16, wobei das Prozessiergut (33) und mindestens ein weiteres Prozessiergut (43) in den Temperiereinheiten (3, 4) angeordnet und anschließend temperiert werden.

18. Verfahren nach Anspruch 17, wobei
- der Temperierstapel (2) in einem Hohlraum (301) eines Stapelkorpus (21) angeordnet wird.
- der Stapelkorpus (21) in einer Temperierkammer (31) so angeordnet wird, dass zwischen dem Stapelkorpus (21) und der Temperierkammer (31) ein Zwischenraum (302) entsteht und
- ein Gasdruck eines Spülgases in dem Zwischenraum (302) hergestellt wird.

19. Verfahren nach Anspruch 18, wobei im Zwischenraum (302) zwischen Temperierkammer und dem Stapelkorpus ein Gasdruck eines Spülgases erzeugt wird, der grösser ist als der Gasdruck des Hohlraums des Stapelkorpus.

20. Verfahren nach Anspruch 19, wobei durch eine Öffnung eine derartige Verbindung zwischen Zwischenraum (302) und Hohlraum (301) hergestellt wird, so dass ein Druckgradient zwischen Hohlraum und Zwischenraum eingestellt werden kann.

21. Verfahren nach einem der Ansprüche 17 bis 20, bei dem als Prozessiergut und/oder weiteres Prozessiergut ein Mehrschichtkörper mit einer Schicht und mindestens einer weiteren Schicht verwendet wird.

22. Verfahren nach einem der Ansprüche 17 bis 21 zur Herstellung eines photovoltaischen Dünnschicht-Chalkopyritabsorbers einer Solarzelle und/ oder eines Solarmodules.

## Claims

1. Device for simultaneous tempering of a plurality of process goods (33, 43) in a specific gas atmosphere (50) through the acceptance of an amount of energy by a process good (33, 43) by means of absorption of specific electromagnetic radiation (34, 44) and through the acceptance of at least a further amount of energy by at least one further process good (43, 33) by means of absorption of at least one further specific electromagnetic radiation (44, 34), wherein the device has
- a tempering unit (3) with at least one energy source (32) for producing the electromagnetic radiation (34) and
- at least one further tempering unit (4) with at least one further energy source (42) for producing the further electromagnetic radiation (44), wherein
- the tempering units (3, 4) have an open tempering container (10), in which the process good (33, 43) is arranged, and the tempering containers (10) have available closable gas openings (11) for evacuating and filling the tempering containers (10) with process gas, wherein
- the tempering units (3, 4) are arranged one over another in a tempering stack (2), such that
- in a specific stack direction (22) of the tempering stack (2), the process good (33) is arranged between the energy source (32) of the tempering unit (3) and the further energy source (42) of the further tempering unit (4), and the further energy source (42) [is arranged] between the process good (33) and the further process good (43), and wherein
- the gas openings (11) of the tempering containers (10) are connected to each other such that a common process-gas atmosphere is created in the tempering containers (10).

2. Device according to claim 1, wherein at least one of the tempering units (3, 4) has at least one additional energy source (7) for producing an additional amount of energy and for accepting the additional amount of energy by the process good of the tempering unit.

3. Device according to claim 1 or 2, wherein at least one of the tempering units has at least one reflecting element (5) to form a radiation field of at least one of the electromagnetic radiations.

4. Device according to claim 3, wherein the reflecting element (5) is partially permeable to at least one of the electromagnetic radiations.

5. Device according to one of claims 1 through 4, wherein at least one of the tempering units has at least one means (62) for cooling the process good.

6. Device according to one of claims 1 through 5, wherein at least one of the energy sources is arranged in a shroud (60) that is at least partially transparent to the electromagnetic radiation of the energy source.

7. Device according to claim 6, wherein the shroud (60) of the energy source has the means for cooling (62).

8. Device according to claim 6 or 7, in which the shroud (60) of the energy source has the reflecting element (52).

9. Device according to one of claims 1 through 8, wherein at least one of the tempering units (3, 4) has a tempering container (10) with a container wall.

10. Device according to one of claims 1 through 9, wherein the tempering stack (2) has a stack body (21) with a body wall.

11. Device according to one of claims 1 through 10, wherein the tempering stack (2) and/or the stack body (21) are arranged in a tempering chamber (31) with a chamber wall.

12. Device according to claim 10 or 11, wherein the stack body and/or the tempering chamber can be heat controlled.

13. Device according to claim 11 or 12, wherein the tempering chamber (31) is provided with a vacuum-tight door (311), on which, inside the tempering chamber (31), a door (201) of the stack body (21) that can be opened and closed independently of the door (311) of the tempering chamber (31) is arranged.

14. Device according to one of claims 1 through 13, wherein at least one of the process goods is a multilayer body with at least one layer that has a specific absorption for at least one of the electromagnetic radiations.

15. Device according to one of claims 1 through 14, wherein at least one of the tempering units has at least one transparent body (8, 9) that has a specific absorption and a specific transmission for at least one of the electromagnetic radiations, and that is arranged in the radiation field of the electromagnetic radiation between the energy source of the electromagnetic radiation and one of the process goods.

16. Device according to claim 15, wherein the shroud of the energy source, the tempering container, the stack body, the temperature chamber, the transparent body, and/or the reflection body comprise material that is inert to the gas (12).

17. Method for simultaneous tempering of one process good (33) and at least one further process good (43) using the device according to one of claims 1 through 16, wherein the process good (33) and at least one further process good (43) are arranged in the tempering units (3, 4) and then tempered.

18. Method according to claim 17, wherein
- the tempering stack (2) is arranged in a hollow space (301) of a stack body (21).
- the stack body (21) is arranged in a tempering chamber (31) such that an intermediate space (302) is created between the stack body (21) and the tempering chamber (31), and
- a gas pressure of a scavenging gas is produced in the intermediate space (302).

19. Method according to claim 18, wherein a gas pressure of a scavenging gas is produced in the intermediate space (302) between tempering chamber and the stack body, which is greater than the gas pressure of the hollow space of the stack body.

20. Method according to claim 19, wherein, through an opening, a connection is produced between the intermediate space (302) and the hollow space (301) such that a pressure gradient can be set between the hollow space and the intermediate space.

21. Method according to one of claims 17 through 20, in which a multilayer body with one layer and at least one additional layer is used as the process good and/or further process good.

22. Process according to one of claims 17 through 21 for producing a photovoltaic thin-film chalcopyrite absorber of a solar cell and/or a solar module.

## Revendications

1. Dispositif pour réaliser une trempe simultanée de plusieurs éléments à traiter (33, 43) dans une atmosphère gazeuse définie (50) pour faire absorber une quantité d'énergie par un élément à traiter (33, 43) par absorption d'un rayonnement électromagnétique défini (34, 44) et pour faire absorber au moins une autre quantité d'énergie par au moins un autre élément à traiter (43, 33) par absorption d'au moins un autre rayonnement électromagnétique défini (44, 34),
le dispositif présentant
- une unité de trempe (3) avec au moins une source d'énergie (32) pour générer le rayonnement électromagnétique (34) ; et
- au moins une autre unité de trempe (4) avec au moins une autre source d'énergie (42) pour générer l'autre rayonnement électromagnétique (44) ;
suivant lequel les unités de trempe (3, 4) présentent un récipient de trempe ouvert (10) dans lequel l'élément à traiter (33, 43) est disposé et le récipient de trempe (10) dispose d'ouvertures de gaz (11) pouvant être fermées pour le vidage et le remplissage du récipient de trempe (10) par du gaz de traitement ;
suivant lequel les unités de trempe (3, 4) sont disposées les unes au-dessus des autres en un empilement de trempe (2) de telle sorte que
dans une direction d'empilement définie (22) de l'empilement de trempe (2) entre la source d'énergie (32) de l'unité de trempe (3) et l'autre source d'énergie (42) de l'autre unité de trempe (43) est disposé l'élément à traiter (33) et entre l'élément à traiter (33) et l'autre élément à traiter (43) est disposée l'autre source d'énergie (42), et
suivant lequel les ouvertures de gaz (11) du récipient de trempe (10) sont reliées les unes aux autres de telle sorte que soit créée une atmosphère gazeuse de traitement commune dans les récipients de trempe (10).

2. Dispositif selon la revendication 1, suivant lequel au moins l'une des unités de trempe (3, 4) présente au moins une source d'énergie supplémentaire (7) pour la génération d'une quantité d'énergie supplémentaire et pour faire absorber la quantité d'énergie supplémentaire par l'élément à traiter de l'unité de trempe.

3. Dispositif selon l'une des revendications 1 ou 2, suivant lequel au moins l'une des unités de trempe présente au moins un corps de réflexion (5) pour former un champ de rayonnement d'au moins l'un des rayonnements électromagnétiques.

4. Dispositif selon la revendication 3, suivant lequel le corps de réflexion (5) est partiellement transparent à au moins l'un des rayonnements électromagnétiques.

5. Dispositif selon l'une des revendications 1 à 4, suivant lequel au moins l'une des unités de trempe présente au moins un moyen (62) pour le refroidissement de l'élément à traiter.

6. Dispositif selon l'une des revendications 1 à 5, suivant lequel au moins l'une des sources d'énergie est disposée dans une enveloppe (60) qui est au moins partiellement transparente au rayonnement électromagnétique de la source d'énergie.

7. Dispositif selon la revendication 6, suivant lequel l'enveloppe (60) de la source d'énergie présente le moyen de refroidissement (62).

8. Dispositif selon l'une des revendications 6 ou 7, suivant lequel l'enveloppe (60) de la source d'énergie présente le corps de réflexion (52).

9. Dispositif selon l'une des revendications 1 à 8, suivant lequel au moins l'une des unités de trempe (3, 4) présente un récipient de trempe (10) ayant une paroi de récipient.

10. Dispositif selon l'une des revendications 1 à 9, suivant lequel l'empilement de trempe (2) présente un corps d'empilement (2) avec une paroi de corps.

11. Dispositif selon l'une des revendications 1 à 10, suivant lequel l'empilement de trempe (2) et/ou le corps d'empilement (21) sont disposés dans une chambre de trempe (31) ayant une paroi de chambre.

12. Dispositif selon l'une des revendications 10 ou 11, suivant lequel le corps d'empilement et/ou la chambre de trempe sont aptes à être soumis à une trempe.

13. Dispositif selon l'une des revendications 11 ou 12, suivant lequel la chambre de trempe (31) est dotée d'une porte (311) étanche au vide, sur laquelle, à l'intérieur de la chambre de trempe (31), est disposée une porte (201) du corps d'empilement (21), qui peut être ouverte et fermée indépendamment de la porte (311) de la chambre de trempe (31).

14. Dispositif selon l'une des revendications 1 à 13, suivant lequel au moins l'un des éléments à traiter est un corps multicouches ayant au moins une couche qui présente une absorption définie d'au moins l'un des rayonnements électromagnétiques.

15. Dispositif selon l'une des revendications 1 à 14, suivant lequel au moins l'une des unités de trempe présente au moins un corps transparent (8, 5), qui présente une absorption définie et une transmission définie pour au moins l'un des rayonnements électromagnétiques et qui est disposé dans le champ de rayonnement du rayonnement électromagnétique entre la source d'énergie du rayonnement électromagnétique et l'un des éléments à traiter.

16. Disposition selon la revendication 15, suivant lequel l'enveloppe de la source d'énergie, le récipient de trempe, le corps d'empilement, la chambre de trempe, le corps transparent et/ou le corps de réflexion présentent un matériau qui est inerte vis-à-vis du gaz (12).

17. Procédé pour réaliser une trempe simultanée d'un élément à traiter (33) et d'au moins un autre élément à traiter (43) à l'aide du dispositif tel que défini à l'une des revendications 1 à 16, suivant lequel l'élément à traiter (33) et au moins un autre élément à traiter (43) sont disposés dans les unités de trempe (3, 4) et ensuite soumis à une trempe.

18. Procédé selon la revendication 17, suivant lequel :
- l'empilement de trempe (2) est disposé dans un espace creux (301) d'un corps d'empilement (21) ;
- le corps d'empilement (21) est disposé dans une chambre de trempe (31) de telle sorte qu'entre le corps d'empilement (21) et la chambre de trempe (3) se trouve un espace intermédiaire (302) ; et
- une pression de gaz d'un gaz de rinçage est produite dans l'espace intermédiaire (302).

19. Procédé selon la revendication 18, suivant lequel, dans l'espace intermédiaire (302) entre la chambre de trempe et le corps d'empilement, est produite une pression de gaz d'un gaz de rinçage qui est supérieure à la pression de gaz de l'espace creux du corps d'empilement.

20. Procédé selon la revendication 19, suivant lequel par une ouverture une liaison entre l'espace intermédiaire (302) et l'espace creux (301) est produite de telle sorte qu'un gradient de pression entre l'espace creux et l'espace intermédiaire peut être établi.

21. Procédé selon l'une des revendications 17 à 20, suivant lequel comme élément à traiter et/ou autre élément à traiter, on utilise un corps multicouches avec une couche et au moins une autre couche.

22. Procédé selon l'une des revendications 17 à 21, pour la fabrication d'un absorbeur de chalcopyrite en couche mince photovoltaïque d'une cellule solaire et/ou d'un module solaire.
